(19) Europäisches Patentamt
European Patent Office
Office européen des brevets

(11) **EP 4 779 907 A1**

(12) **EUROPEAN PATENT APPLICATION**
published in accordance with Art. 153(4) EPC

(43) Date of publication:
**22.07.2026 Bulletin 2026/30**

(21) Application number: **23952599.1**

(22) Date of filing: **20.09.2023**

(51) International Patent Classification (IPC):
**H04L 1/00** (2006.01)

(52) Cooperative Patent Classification (CPC):
**H04L 1/00**

(86) International application number:
**PCT/CN2023/120173**

(87) International publication number:
**WO 2025/059939 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **HUAWEI TECHNOLOGIES CO., LTD.**
**Shenzhen 518129 (CN)**

(72) Inventors:
- **QIN, Kangjian**
  **Shenzhen, Guangdong 518129 (CN)**
- **ZHANG, Huazi**
  **Shenzhen, Guangdong 518129 (CN)**
- **TONG, Jiajie**
  **Shenzhen, Guangdong 518129 (CN)**
- **LIU, Ke**
  **Shenzhen, Guangdong 518129 (CN)**
- **WANG, Xianbin**
  **Shenzhen, Guangdong 518129 (CN)**
- **WANG, Jun**
  **Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **DATA PROCESSING METHOD AND APPARATUS**

(57) Embodiments of this application provide a data processing method and apparatus. The method includes: A first communication apparatus obtains decoding capability information of a second communication apparatus; performs segmentation processing on a first information bit based on the decoding capability information of the second communication apparatus, to obtain information bits through segmentation; performs encoding processing on the information bits obtained through segmentation, to obtain codeword bits; and outputs the codeword bits. In the method, the first communication apparatus performs segmentation processing on the first information bit based on the decoding capability information of the second communication apparatus, to obtain the information bits through segmentation, then encodes the information bits obtained through segmentation, to obtain the codeword bits, and outputs the codeword bits to the second communication apparatus. This can ensure performance of the second communication apparatus in performing decoding.

FIG. 3

**Description**

TECHNICAL FIELD

This application relates to the field of communication technologies, and in particular, to a data processing method and apparatus.

BACKGROUND

A segmentation encoding technology is an encoding technology in which entire data is divided into several segments for separate encoding. This technology is widely applied in wireless communication scenarios. Currently, a segmentation manner mainly includes a polar code (polar code) segmentation manner and a low-density parity-check (low-density parity-check, LDPC) segmentation manner. In the polar code segmentation manner, a segment quantity is determined based on a payload size, or a segment quantity is determined based on both a payload size and a physical resource size. In the LDPC segmentation manner, a segment quantity is mainly determined based on a code length and a code rate. However, capability information (for example, a decoding capability) and a key performance indicator (key performance indicator, KPI) of a receiving apparatus (for example, a terminal device) are not considered in a current segmentation manner. Consequently, performance of the receiving apparatus in performing decoding is low.

In view of the foregoing problem, currently, a data processing method needs to be urgently proposed, so that segmentation processing can be performed on to-be-encoded data based on decoding capability information of the receiving apparatus, to effectively ensure subsequent decoding performance of the receiving apparatus.

SUMMARY

This application provides a data processing method and apparatus, so that segmentation processing can be performed on to-be-encoded information bits based on decoding capability information of a receiving apparatus, to effectively ensure decoding performance of the receiving apparatus.

According to a first aspect, this application provides a data processing method, and the method may be implemented by a first communication apparatus. The first communication apparatus may be but is not limited to a terminal device, a network device, a component in a terminal device, or a component in a network device. The component in this application may include, for example, at least one of a chip, a chip system, a processor, a transceiver, a processing unit, or a transceiver unit. For example, an execution body is the first communication apparatus. The steps of the method may include: obtaining decoding capability information of a second communication apparatus; performing segmentation processing on a first information bit based on the decoding capability information of the second communication apparatus, to obtain information bits through segmentation; performing encoding processing on the information bits obtained through segmentation, to obtain codeword bits; and outputting the codeword bits.

In the solutions of this application, the first communication apparatus may perform segmentation processing on the first information bit based on the decoding capability information of the second communication apparatus, to ensure performance of the second communication apparatus in performing decoding after receiving the segmented codeword bits.

In this embodiment of this application, that the first communication apparatus obtains the decoding capability information of the second communication apparatus may be implemented in but is not limited to the following manners:

Manner 1: Obtain first information, where the first information indicates the decoding capability information of the second communication apparatus.

Manner 2: Obtain capability information of the second communication apparatus, where a first field in the capability information of the second communication apparatus indicates decoding capability information of the second communication apparatus.

Manner 3: Obtain type information of the second communication apparatus, where the type information of the second communication apparatus includes the decoding capability information of the second communication apparatus.

In a possible implementation, the first information, the capability information of the second communication apparatus, or the type information of the second communication apparatus may come from the second communication apparatus.

In the foregoing several manners, the first communication apparatus may flexibly and effectively obtain the decoding capability information of the second communication apparatus.

In a possible implementation, the decoding capability information of the second communication apparatus is a maximum length $N_{max}$ that is of a codeword and that is supported by the second communication apparatus for decoding.

In this implementation, the maximum length $N_{max}$ that is of the codeword and that is supported by the second communication apparatus for decoding is used as the decoding capability information of the second communication apparatus, and is used for segmentation processing, so that the subsequent decoding performance of the second communication apparatus can be effectively ensured.

In another possible implementation, the decoding capability information of the second communication apparatus is a minimum code rate $R_{min}$ that is of a codeword and that is supported by the second communication apparatus for decoding, and $R_{min} = N_{max}$, where A is a quantity of bits of the first information bit, and $N_{max}$ is a maximum length that is of the codeword and that is supported by the second communication apparatus for decoding.

In this implementation, the first communication apparatus may obtain the minimum code rate $R_{min}$ that is of the codeword and that is supported by the second communication apparatus for decoding, to effectively obtain, through calculation, the maximum length $N_{max}$ that is of the codeword and that is supported by the second communication apparatus for decoding.

In a possible implementation, that the first communication apparatus performs segmentation processing on the first information bit based on the decoding capability information of the second communication apparatus, to obtain the information bits through segmentation may include: performing segmentation processing based on a code rate, the first information bit, and the maximum length $N_{max}$ that is of the codeword and that is supported by the second communication apparatus for decoding.

In embodiments of this application, the code rate refers to a current encoding code rate.

In this implementation, the first communication apparatus may perform segmentation processing on the first information bit based on the current encoding code rate and the maximum length of that is of the codeword and that is supported by the second communication apparatus for decoding, to ensure the subsequent performance of the second communication apparatus in performing decoding.

In a possible implementation, that the first communication apparatus performs segmentation processing based on the code rate, the first information bit, and the maximum length $N_{max}$ that is of the codeword and that is supported by the second communication apparatus for decoding includes: determining an initial segmentation value C' based on a quantity L of bits of cyclic redundancy check CRC concatenated to each segment, the code rate, $N_{max}$, and a quantity of bits of the first information bit, where L is a preset integer greater than or equal to 0, and C' is an integer greater than 1 or equal to 1; corresponding to the code rate being greater than or equal to a preset code rate, determining that a segment quantity is equal to C'; and corresponding to the code rate being less than the preset code rate, determining that the segment quantity is equal to C1, where C1 is a positive integer less than or equal to C'.

In this embodiment of this application, the initial segmentation value C' may satisfy the following formula:

$$C' = \left\lceil \frac{A}{K_{cb} - L} \right\rceil,$$

where

$K_{cb}$ is a maximum value of a quantity of information bits of each segment obtained through segmentation, $K_{cb} = \lceil R \times N_{max} \rceil$, R is the code rate, A is the quantity of bits of the first information bit, $\lceil \ \rceil$ is a ceiling symbol, $C1 = \lceil C'/ \ y \rceil$, and y is an integer greater than or equal to 1.

In this implementation, the initial segmentation value is first obtained through calculation based on the quantity L of bits of the CRC concatenated to each segment, the code rate, $N_{max}$, and the quantity of bits of the first information bit. If the current code rate is large (that is, greater than or equal to the preset code rate), the segment quantity is set to the initial segmentation value, to ensure the decoding performance of the second communication apparatus. If the current code rate is small (that is, less than the preset code rate), the segment quantity is set to be less than the initial segmentation value, so that a size of each segment of information bits obtained through segmentation is increased, and the code rate may be increased, to avoid a problem of low decoding performance caused by a low code rate.

In a possible implementation, that the first communication apparatus performs encoding processing on the information bits obtained through segmentation, to obtain the codeword bits includes: concatenating a segment of CRC with the quantity of L bits at a tail of each segment of information bits obtained through segmentation, to obtain each segment of concatenated information bits; and encoding each segment of concatenated information bits, to obtain each segment of codeword bits.

In this implementation, the first communication apparatus may perform a procedure such as encoding after concatenating the L-bit CRC at the tail of each segment of information bits, to ensure correctness and integrity of transmission of each segment of information bits.

In a possible implementation, when a quantity of transmission resource units occupied by C1 codeword bits is less than a total quantity of transmission resource units, the method further includes: The first communication apparatus retransmits a part of codeword bits or all of codeword bits in the C1 segments of codeword bits via a remaining transmission resource unit in the total transmission resource units.

In this implementation, when the segment quantity is C1, if there is still a remaining transmission resource unit after C1 segments of codeword bits are transmitted, the part or all of the codeword bits in the C1 segments of codeword bits may be retransmitted via the remaining transmission resource unit, so as to ensure integrity of the transmission of the C1 segments of codeword bits and avoid a loss.

In a possible implementation, that the first communication apparatus performs segmentation processing on the first information bit based on the decoding capability information of the second communication apparatus, to obtain the information bits through segmentation may include: performing segmentation processing based on a total quantity of transmission resource units, a modulation order, the first information bit, and the maximum length $N_{max}$ that is of the codeword and that is supported by the second communication apparatus for decoding, where $N_{max}$ is a value greater than 0.

In this implementation, the first communication apparatus may perform effective segmentation processing based on the total quantity of transmission resource units, the modulation order, the first information bit, and $N_{max}$, to ensure the subsequent performance of the second communication apparatus in performing decoding.

In a possible implementation, that the first communication apparatus performs segmentation processing based on the total quantity of transmission resource units, the modulation order, the first information bit, and the maximum length $N_{max}$ that is of the codeword and that is supported by the second communication apparatus for decoding includes: first determining an initial segmentation value $C_3$ based on the total quantity of transmission resource units, the modulation order, and the maximum length $N_{max}$ that is of the codeword and that is supported by the second communication apparatus for decoding, where $C_3$ is a positive integer; then, calculating a quantity of bits of a remaining transmission resource based on the total quantity of transmission resource units, the modulation order, the initial segmentation value $C_3$, and the maximum length $N_{max}$ that is of the codeword and that is supported by the second communication apparatus for decoding; if the quantity of bits of the remaining transmission resource is less than a preset value, determining that the segment quantity is equal to $C_3$; and if the quantity of bits of the remaining transmission resource is not less than the preset value, determining that the segment quantity is equal to $C_3 + 1$.

In embodiments of this application, the initial segmentation value $C_3$ may satisfy

$$C_3 = \lfloor Q_m \times E_{total}/N_{max} \rfloor .$$

The quantity of bits of the remaining transmission resource may satisfy $B_{rest} = E_{total} \times Q_m - C_3 \times N_{max}$.
when

$$B_{rest} < z \cdot N_{max}, C = C_3;$$

or
when

$$B_{rest} \geq z \cdot N_{max}, C = C_3 + 1,$$

where

$Q_m$ is the modulation order, $E_{total}$ is the total quantity of transmission resource units, $B_{rest}$ is the quantity of bits of the remaining transmission resource, $z \cdot N_{max}$ is the preset value, z is a value greater than 0 and less than 1, and $\lfloor \ \rfloor$ is a floor symbol.

In this implementation, the first communication apparatus first obtains the initial segmentation value through calculation based on the total quantity of transmission resource units, the modulation order, and the maximum length $N_{max}$ that is of the codeword and that is supported by the second communication apparatus for decoding, and then obtains the quantity of bits of the remaining transmission resource through calculation with reference to the current modulation order when segmentation is performed based on the initial segmentation value. If the calculated quantity of bits of the remaining transmission resource is small (that is, less than the preset value), an actual segment quantity is set to the initial segmentation value. If the calculated quantity of bits of the remaining transmission resource is large (that is, not less than the preset value), the actual segment quantity is set to be one more than the initial segmentation value, so that the decoding performance of the second communication apparatus can be ensured, and the transmission resource can be effectively used.

In a possible implementation, when a quantity of transmission resource units occupied by $C_3$ segments of codeword bits is less than the total quantity of transmission resource units, the method further includes: The first communication apparatus retransmits a part of codeword bits or all of codeword bits in the $C_3$ segments of codeword bits via a remaining transmission resource unit in the total transmission resource units.

In this implementation, when the segment quantity is $C_3$, if there is still a remaining transmission resource unit after $C_3$ segments of codeword bits are transmitted, the part or all of the codeword bits in the $C_3$ segments of codeword bits may be retransmitted via the remaining transmission resource unit, so as to ensure integrity of the transmission of the $C_3$ segments of codeword bits and avoid a loss.

In a possible implementation, when a quantity of transmission resource units occupied by first $C_3$ segments of codeword bits in $C_3 + 1$ segments of codeword bits is less than the total quantity of transmission resource units, the method further includes: The first communication apparatus transmits a last segment of codeword bits via a remaining transmission resource unit in the total transmission resource units.

In this embodiment of this application, a size of the first $C_3$ segments of codeword bits in the $C_3 + 1$ segments is equal to the maximum length $N_{max}$ of the codeword and that is supported by the second communication apparatus for decoding, and code rates of all segments in the first $C_3$ segments are the same. A size of a last segment of codeword bits is smaller than $N_{max}$. Therefore, in comparison with code rates of the first $C_3$ segments, a code rate of the last segment is larger.

In this implementation, when the segment quantity is $C_3 + 1$, the first $C_3$ segments of codeword bits are first transmitted via the transmission resource and the last segment of codeword bits are transmitted via the remaining transmission resource unit, so that the decoding performance of the second communication apparatus is ensured, and transmission resources can also be effectively used.

According to a second aspect, this application provides a data processing method, and the method may be implemented by a second communication apparatus. The second communication apparatus may be but is not limited to a network device, a terminal device, a component in a network device, or a component in a terminal device. The component in this application may include, for example, at least one of a chip, a chip system, a processor, a transceiver, a processing unit, or a transceiver unit. For example, an execution body is a second communication apparatus. The method may include: inputting codeword bits, where the codeword bits are obtained by performing encoding processing on information bits obtained through segmentation, and the information bits obtained through segmentation are obtained by a first communication apparatus by performing segmentation processing on a first information bit based on decoding capability information of the second communication apparatus; and performing decoding processing on the codeword bits, to obtain the first information bit.

In the solutions of this application, the first communication apparatus performs segmentation processing on the first information bit based on the decoding capability information of the second communication apparatus, then performs encoding processing on the information bits obtained through segmentation, to obtain the codeword bits, and then outputs the codeword bits. After obtaining the codeword bits, performance of the second communication apparatus in performing decoding processing is high.

In embodiments of this application, that the second communication apparatus further outputs the decoding capability information of the second communication apparatus may include but is not limited to the following manners:

Manner 1: Output first information, where the first information indicates the decoding capability information of the second communication apparatus.

Manner 2: Output capability information of the second communication apparatus, where a first field in the capability information of the second communication apparatus indicates the decoding capability information of the second communication apparatus.

Manner 3: Output type information of the second communication apparatus, where the type information of the second communication apparatus includes the decoding capability information of the second communication apparatus.

The second communication apparatus may flexibly and effectively output the decoding capability information of the second communication apparatus to the first communication apparatus in the foregoing several manners.

In a possible implementation, a maximum length $N_{max}$ that is of a codeword and that is supported by the second communication apparatus for decoding is used as the decoding capability information of the second communication apparatus, and $N_{max}$ is a value greater than 0.

In this implementation, the maximum length $N_{max}$ that is of the codeword and that is supported by the second communication apparatus for decoding is used as the decoding capability information of the second communication apparatus, and is used for segmentation processing, so that subsequent decoding performance of the second communication apparatus can be effectively ensured.

In another possible implementation, the decoding capability information of the second communication apparatus is a minimum code rate $R_{min}$ that is of a codeword and that is supported by the second communication apparatus for decoding, and $R_{min} = N_{max}$, where A is a quantity of bits of the first information bit, and $N_{max}$ is a maximum length that is of the codeword and that is supported by the second communication apparatus for decoding.

In this implementation, the first communication apparatus may obtain the minimum code rate $R_{min}$ that is of the codeword and that is supported by the second communication apparatus for decoding, to effectively obtain, through calculation, the maximum length $N_{max}$ that is of the codeword and that is supported by the second communication apparatus for decoding.

In a possible implementation, the second communication apparatus receives C' segments of codeword bits from the first communication apparatus, where C' is an integer greater than or equal to 1. That the second communication apparatus performs decoding processing on the codeword bits, to obtain the first information bit may include: first performing decoding processing on the C'segments of codeword bits , to obtain C' segments of concatenated information bits; and then removing CRC code from the C' segments of concatenated information bits, to obtain the first information bit.

In this implementation, the second communication apparatus can effectively decode the C' segments of codeword bits, to accurately obtain the first information bit.

In a possible implementation, the second communication apparatus receives, from the first communication apparatus, $C_1$ segments of codeword bits and codeword bits that are a part or all of the $C_1$ segments of codeword bits and that are retransmitted, where C1 is a positive integer less than or equal to C'. That the second communication apparatus performs decoding processing on the codeword bits, to obtain the first information bit may include: first combining soft bits corresponding to the C1 segments of codeword bits and soft bits corresponding to the retransmitted codeword bits, and then performing decoding, to obtain concatenated information bits; and removing CRC code from the concatenated information bits, to obtain the first information bit.

In this implementation, the second communication apparatus can effectively and completely obtain the first information bit.

In a possible implementation, the second communication apparatus receives, from the first communication apparatus, $C_3$ segments of codeword bits and codeword bits that are a part or all of the $C_3$ segments of codeword bits and that are retransmitted, where $C_3$ is a positive integer. That the second communication apparatus performs decoding processing on the codeword bits, to obtain the first information bit may include: first combining soft bits corresponding to the $C_3$ segments of codeword bits and soft bits corresponding to the retransmitted codeword bits, and then performing decoding, to obtain concatenated information bits; and removing CRC code from the concatenated information bits, to obtain the first information bit.

In this implementation, the second communication apparatus can effectively and completely obtain the first information bit.

In a possible implementation, the second communication apparatus receives $C_3 + 1$ segments of codeword bits from the first communication apparatus, where $C_3$ is a positive integer. That the second communication apparatus performs decoding processing on the codeword bits, to obtain the first information bit includes: first performing decoding processing on the $C_3 + 1$ segments of codeword bits, to obtain $C_3 + 1$ segments of concatenated information bits; and then removing CRC code from the $C_3 + 1$ segments of concatenated information bits, to obtain the first information bit.

In this implementation, the second communication apparatus can effectively obtain the first information bit.

According to a third aspect, an embodiment of this application further provides a data processing apparatus. The apparatus may be configured to perform the method in the first aspect. The apparatus may be a first communication apparatus, or the apparatus may be a component (for example, a chip, a chip system, or a circuit) in the first communication apparatus, or may be an apparatus that can be used together with the first communication apparatus.

In a possible implementation, the apparatus may include modules or units that one to one correspond to the method/operations/steps/actions described in the first aspect. The modules or units may be hardware circuits, software, or may be implemented by the hardware circuit in combination with software. In a possible implementation, the apparatus may include a processing unit (which may also be referred to as a processing module) and a communication unit (which may also be referred to as a communication module). The communication unit may be configured to perform a receiving and/or sending function, and the processing unit may be configured to perform the method in the first aspect or any possible implementation of the first aspect.

According to a fourth aspect, an embodiment of this application further provides a data processing apparatus. The apparatus may be configured to perform the method in the second aspect. The apparatus may be a second communication apparatus, or the apparatus may be a component (for example, a chip, a chip system, or a circuit) in the second communication apparatus, or may be an apparatus that can be used together with the second communication apparatus.

In a possible implementation, the apparatus may include modules or units that one to one correspond to the method/operations/steps/actions described in the second aspect. The modules or units may be hardware circuits, software, or may be implemented by the hardware circuit in combination with software. In a possible implementation, the apparatus may include a processing unit (which may also be referred to as a processing module) and a communication unit (which may also be referred to as a communication module). The communication unit may be configured to perform a receiving and/or sending function, and the processing unit may be configured to perform the method in the second aspect or any possible implementation of the second aspect.

According to a fifth aspect, an embodiment of this application provides a data processing apparatus. The apparatus includes at least one processor and a communication interface. The communication interface is configured to communicate with another apparatus. The processor is configured to run a group of programs, to enable the apparatus to implement the method in the first aspect or any possible implementation of the first aspect.

According to a sixth aspect, an embodiment of this application provides a data processing apparatus. The apparatus includes at least one processor and a communication interface. The communication interface is configured to communicate with another apparatus. The processor is configured to run a group of programs, to enable the apparatus to implement the method in the first aspect or any possible implementation of the second aspect.

According to a seventh aspect, an embodiment of this application provides a communication system. The communication system includes the first communication apparatus configured to perform the method in the first aspect or any possible implementation of the first aspect, and the second communication apparatus configured to perform the method in the second aspect or any possible implementation of the second aspect.

According to an eighth aspect, an embodiment of this application further provides a computer storage medium. The storage medium stores a software program. When the software program is read and executed by one or more processors, the method in the first aspect or any possible implementation of the first aspect may be implemented, or the method in the second aspect or any possible implementation of the second aspect may be implemented.

According to a ninth aspect, an embodiment of this application further provides a computer program product including instructions. When the computer program product runs on a computer, the method in the first aspect or any possible implementation of the first aspect is performed, or the method in the second aspect or any possible implementation of the second aspect is performed.

According to a tenth aspect, an embodiment of this application further provides a chip system. The chip system includes a processor, configured to support a first communication apparatus to implement a function in the first aspect, or configured to support a second communication apparatus to implement a function in the second aspect.

In a possible design, the chip system further includes a memory. The memory is configured to store program instructions and data that are necessary for execution of a loading apparatus. The chip system may include a chip, or may include a chip and another discrete component.

It should be noted that, for technical effect that can be achieved in the third aspect to the tenth aspect or any possible implementation of the third aspect to the tenth aspect, correspondingly refer to descriptions of technical effect that can be achieved in the first aspect and the second aspect or any possible implementation of the first aspect and the second aspect. Details are not described herein again.

BRIEF DESCRIPTION OF DRAWINGS

FIG. 1 is a diagram of an architecture of a wireless communication system according to an embodiment of this application;

FIG. 2 is a diagram of a radio signal transmission process in a communication system;

FIG. 3 is a schematic flowchart of a data processing method according to an embodiment of this application;

FIG. 4A is a schematic flowchart of a method in a first embodiment according to an embodiment of this application;

FIG. 4B is a diagram of a segmentation processing manner in a first embodiment according to an embodiment of this application;

FIG. 4C is an example diagram of segmentation processing in a first embodiment according to an embodiment of this application;

FIG. 5A is a diagram of a segmentation processing manner in a second embodiment according to an embodiment of this application;

FIG. 5B is an example diagram of segmentation processing in a second embodiment according to an embodiment of this application;

FIG. 5C shows decoding performance of segment quantities corresponding to different code rates in Embodiment 1 and Embodiment 2 of this application;

FIG. 6A is a diagram of obtaining capability information of a terminal device according to an embodiment of this application;

FIG. 6B is another diagram of obtaining capability information of a terminal device according to an embodiment of this application;

FIG. 6C is still another diagram of obtaining capability information of a terminal device according to an embodiment of this application;

FIG. 7 is a diagram of a structure of a data processing apparatus according to an embodiment of this application;

FIG. 8 is a diagram of a structure of another data processing apparatus according to an embodiment of this application; and

FIG. 9 is a diagram of a structure of a chip according to an embodiment of this application.

## DESCRIPTION OF EMBODIMENTS

The following clearly and completely describes the technical solutions in embodiments of this application with reference to the accompanying drawings in embodiments of this application. Terms used in the following embodiments are merely intended to describe specific embodiments, but are not intended to limit this application. The terms "one", "a", "the", "the foregoing", and "this" of singular forms used in this specification and the appended claims of this application are also intended to include expressions such as "one or more", unless otherwise specified in the context clearly. It should be further understood that, in embodiments of this application, "one or more" refers to one, two, or more, and "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects.

Reference to "one embodiment", "some embodiments", or the like described in this specification means that a specific feature, structure, or characteristic described with reference to the embodiment is included in one or more embodiments of this application. The terms "include", "have", and their variants in this application all mean "include but are not limited to", unless otherwise specifically emphasized in another manner. The term like "example" or "for example" is used to represent an example, an illustration, or a description. Any embodiment or design scheme described with "example" or "for example" should not be explained as being more preferred or having more advantages than another embodiment or design scheme. Use of the term such as "example" or "for example" is intended to present a related concept in a specific manner for ease of understanding.

"A plurality of" in embodiments of this application means "greater than or equal to two". It should be noted that in the descriptions of embodiments of this application, the terms such as "first" and "second" are merely intended for distinction in description, but should not be construed as indicating or implying relative importance or indicating or implying a sequence. In addition, the term "indicating" mentioned in descriptions of embodiments of this application may include directly indicating and indirectly indicating. When a piece of indication information indicates A, the indication information may directly indicate A or indirectly indicate A, but this does not mean that the indication information necessarily carries A.

To better understand the solutions in embodiments of this application, the following first describes an application scenario and an existing problem of embodiments of this application. It should be noted that, the application scenario is intended to make embodiments of this application easier to understand, but should not be construed as a limitation to the protection scope claimed in this application.

The segmentation encoding technology is an encoding technology in which entire data is divided into several segments for separate encoding. This technology is widely applied in wireless communication scenarios. Currently, a segmentation manner mainly includes a polar code (polar code) segmentation manner and a low-density parity-check (low-density parity-check, LDPC) segmentation manner. In the polar code segmentation manner, a segment quantity is determined based on a payload size, or a segment quantity is determined based on both a payload size and a physical resource size. In the LDPC segmentation manner, a segment quantity is mainly determined based on a code length and a code rate. However, requirements of capability information (for example, a decoding capability) and a key performance indicator (key performance indicator, KPI) of a receiving apparatus (for example, a terminal device) are not considered in a current segmentation manner. Consequently, performance of the receiving apparatus in performing decoding is low.

In view of the foregoing problem, currently, a data processing method needs to be urgently proposed, so that segmentation processing may be performed on to-be-encoded data based on decoding capability information of the receiving apparatus, to effectively ensure subsequent decoding performance of the receiving apparatus.

The method provided in embodiments of this application may be applied to a 4th generation (4th generation, 4G) communication system, for example, a long term evolution (long term evolution, LTE) communication system; or may be applied to a 5th generation (5th generation, 5G) communication system, for example, a 5G new radio (new radio, NR) communication system; or may be applied to various future communication systems, for example, a 6th generation (6th generation, 6G) communication system. The method provided in embodiments of this application may be further applied to three application scenarios, namely, an enhanced mobile broadband (enhanced mobile broadband, eMBB), ultra-reliable low-latency communications (ultra-reliable low-latency communications, URLLC), and enhanced machine-type communication (enhanced machine-type communication, eMTC) of a narrowband internet of things system (narrow band-internet of things, NB-IoT), a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronous code division multiple access (time division-synchronization code division multiple access, TD-SCDMA) system, or a next-generation 5G mobile communication system. The method provided in embodiments of this application may be further applied to a satellite communication system. The satellite communication system may be integrated with the foregoing communication system. In addition, the method provided in embodiments of this application may further affect a physical uplink control channel (physical uplink control channel, PUCCH) enhancement scenario, and PUCCH coverage is enhanced through maximum likelihood (maximum likelihood, ML) detection.

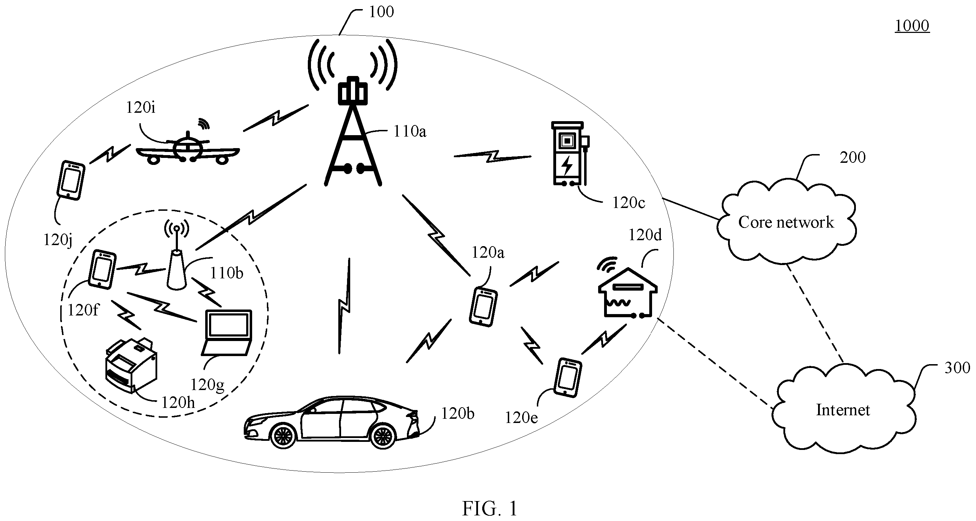

FIG. 1 shows a possible and non-limiting architecture of a communication system to which an embodiment of this application is applicable. As shown in FIG. 1, the communication system 1000 includes a radio access network (radio access network, RAN) 100, and a core network (core network, CN) 200. Optionally, the communication system 1000 may further include an internet 300. The RAN 100 includes at least one network device (for example, 110a and 110b in FIG. 1, which are collectively referred to as 110) and at least one terminal device (for example, 120a to 120j in FIG. 1, which are collectively referred to as 120). The RAN 100 may further include another RAN node, for example, a wireless relay device and/or a wireless backhaul device (not shown in FIG. 1). The terminal device 120 is connected to the network device 110 in a wireless manner. The network device 110 is connected to the core network 200 in a wireless or wired manner. A core network device in the core network 200 and the network device 110 in the RAN 100 may be different physical devices, or may be a same physical device that integrates a logical function of the core network and a logical function of the radio access network.

The RAN 100 may be a cellular system related to a 3rd generation partnership project (3rd generation partnership project, 3GPP), for example, a 4th generation (4th generation, 4G) mobile communication system, a 5th generation (5th generation, 5G) mobile communication system, or an evolved system after 5G (for example, a 6G mobile communication system). The RAN 100 may alternatively be an open access network (open RAN, O-RAN or ORAN), a cloud radio access network (cloud radio access network, CRAN), or a Wi-Fi system. The RAN 100 may alternatively be a communication system that integrates two or more of the foregoing systems.

It may be understood that FIG. 1 shows only a possible architecture of the communication system to which embodiments of this application may be applied. In another possible scenario, the architecture of the communication system may alternatively include another device.

The network device 110 is a node in the radio access network (radio access network, RAN), and may also be referred to as an access network device or a RAN node (or device). The network device 110 is configured to help the terminal device implement wireless access. A plurality of network devices 110 in the communication system 1000 may be nodes of a same type, or may be nodes of different types. In some scenarios, roles of the network device 110 and the terminal device 120 are relative. For example, a network element 120i in FIG. 1 may be a helicopter or an uncrewed aerial vehicle, and may be configured as a mobile base station. For a terminal device 120j that accesses the RAN 100 through the network element 120i, the network element 120i is a base station. However, for the base station 110a, the network element 120i is a terminal device. The network device 110 and the terminal device 120 are sometimes referred to as communication apparatuses. For example, network elements 110a and 110b in FIG. 1 may be understood as communication apparatuses having a base station function, and the network elements 120a to 120j may be understood as communication apparatuses having a terminal device function.

In a possible scenario, the network device may be a base station (base station), an evolved base station (evolved NodeB, eNodeB), a transmission reception point (transmission reception point, TRP), a transmission point (transmission point, TP), a next-generation NodeB (next-generation NodeB, gNB), a next-generation base station in a 6th generation (6th generation, 6G) mobile communication system, a base station in a future mobile communication system, a satellite, an access point (access point, AP) in a Wi-Fi system, an integrated access and backhaul (integrated access and backhaul, IAB) node, or a network device that is in a non-terrestrial network (non-terrestrial network, NTN) communication system of a mobile switching center and that may be deployed on a high-altitude platform or a satellite, or the like. The network device may be a macro base station (for example, 110a in FIG. 1), a micro base station or an indoor base station (for example, 110b in FIG. 1), a relay node or a donor node, or a radio controller in a CRAN scenario. The network device may alternatively be a device with a base station function in device to device (device to device, D2D) communication, internet of vehicles communication, uncrewed aerial vehicle communication, or machine communication. Optionally, the network device may alternatively be a server, a wearable device, a vehicle, a vehicle-mounted device, or the like. For example, an access network device in a vehicle-to-everything (vehicle-to-everything, V2X) technology may be a road side unit (road side unit, RSU).

In another possible scenario, a plurality of network devices collaborate to assist the terminal device in implementing wireless access, and different network devices separately implement a part of functions of the base station. For example, the network device may be a central unit (central unit, CU), a distributed unit (distributed unit, DU), a CU-control plane (control plane, CP), a CU-user plane (user plane, UP), a radio unit (radio unit, RU), or the like. The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network CN. This is not limited herein.

It should be noted that in different systems, the CU (or the CU-CP and the CU-UP) or the DU may have different names, but a person skilled in the art may understand meanings of the names. For example, in an open radio access network (open radio access network, O-RAN) system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any unit in the CU (or the CU-CP and the CU-UP), the DU, and the RU in this application may be implemented by a software module, a hardware module, or a combination of a software module and a hardware module.

A form of the network device is not limited in embodiments of this application. An apparatus for implementing a function of a network device may be a network device, or may be an apparatus, for example, a chip system, that can support a network device to implement the function. The apparatus may be mounted in the network device or used together with the network device.

The terminal device 120 may also be referred to as a terminal, user equipment (user equipment, UE), a mobile station (mobile station, MS), a mobile terminal (mobile terminal, MT), or the like; or is a device that provides a user with voice or data connectivity; or may be an internet of things device. For example, the terminal device includes a handheld device, a vehicle-mounted device, or the like that has a wireless connection function. Currently, the terminal device may be a mobile phone, a tablet computer, a notebook computer, a palmtop computer, a mobile internet device (mobile internet device, MID), a wearable device (for example, a smartwatch, a smart band, or a pedometer), a vehicle-mounted device (for example, a vehicle, a bicycle, an electric vehicle, an airplane, a ship, a train, or a high-speed train), a satellite terminal, a virtual reality (virtual reality, VR) device, an augmented reality (augmented reality, AR) device, a smart point of sale (point of sale, POS) machine, customer-premises equipment (customer-premises equipment, CPE), a wireless terminal in industrial control, a smart home device (for example, a refrigerator, a television, an air conditioner, or an electricity meter), a smart robot, a robot arm, a workshop device, a wireless terminal in self-driving, a wireless terminal in telemedicine, a wireless terminal in a smart grid (smart grid), a wireless terminal in transportation safety, a wireless terminal in a smart city, a wireless terminal in a smart home, a flight device (for example, a smart robot, a hot air balloon, an uncrewed aerial vehicle, or an airplane), or the like. The terminal device may alternatively be another device having functions of a terminal. For example, the terminal device may alternatively be a device that functions as a terminal in D2D communication.

A device form of the terminal device is not limited in embodiments of this application. An apparatus for implementing a function of a terminal device may be a terminal device, or may be an apparatus, for example, a chip system, that can support a terminal device to implement the function. The apparatus may be mounted in a terminal device or used together with a terminal device. In embodiments of this application, the chip system may include a chip, or may include a chip and another discrete component.

The following describes in detail the method provided in embodiments of this application with reference to the communication system shown in FIG. 1.

To better understand the solutions provided in embodiments of this application, the following first describes terms, concepts, and procedures in embodiments of this application. It should be noted that, these explanations are intended to make embodiments of this application easier to understand, but should not be construed as a limitation to the protection scope claimed in this application.

(1) Channel encoding

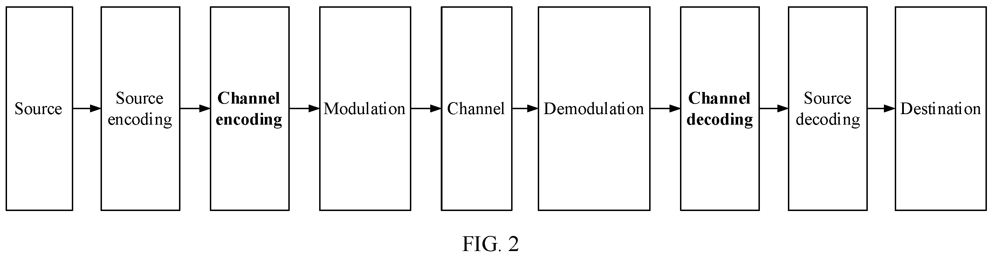

In the communication system transmission procedure shown in FIG. 2, a channel encoding part is located between source encoding and modulation, and is responsible for performing channel encoding on an information bit (or referred to as a bit stream) generated by a source, and after modulation, a modulated symbol is sent to a receive side through a noise channel for demodulation. After demodulation, the receive side performs channel decoding. A channel decoding part is located between demodulation and source decoding, and is responsible for restoring the information bit of the source.

In this embodiment of this application, core network elements are a channel encoding unit and a channel decoding unit. In this application, a length of the information bit may be referred to as a payload size (payload size).

(2) Cyclic redundancy check (cyclic redundancy check, CRC) encoding

CRC encoding is a manner of channel encoding. In a CRC encoding process, CRC encoding is performed on an information bit from a source, to obtain a CRC codeword. For example, a length of the information bit is K. The CRC codeword includes a K-bit information bit and an L-bit check bit (or referred to as check code, CRC code, or the like) concatenated after the K-bit information bit. That is, a length of the CRC codeword is K+L bits, where K and L each are a positive integer.

For a CRC codeword whose check bit length is L, there is a CRC polynomial gCRC whose highest power is L. gCRC may be used to generate an L-bit check bit. Therefore, gCRC may be referred to as a generator polynomial of the check bit. In this application, the power may be replaced with an exponent, and the highest power may be replaced with a highest exponent. The generator polynomial may be determined by a transmit side and a receive side through negotiation, or may be determined through definition in a protocol, preconfiguration, predefinition, or the like. Therefore, the check bit length may be determined based on the polynomial.

The following describes a CRC check code generation process. It is assumed that a message polynomial is M(D). The message polynomial is determined based on a binary information bit that needs to be sent. For example, if a value of an $X^{th}$ bit of the binary information bit is 1, a coefficient of a term whose power is X - 1 in the polynomial is 1, and if a value of a $Y^{th}$ bit of the binary bit is 0, a coefficient of a term whose power is Y - 1 in the polynomial is 0. In other words, the polynomial does not include a term whose power is Y. X and Y each are a positive integer. To obtain a check bit, M(D) is shifted leftward by L bits. In other words, L is added to a power of each term. A polynomial is represented as M(D) * D^R. Herein, * represents a multiplication operation. A remainder obtained by dividing M(D) * D^R by the generator polynomial gCRC is the check bit.

For example, if a generator polynomial of the check bit is gCRCLmax = gCRC4 = D^4 + D + 1, a binary representation of the generator polynomial is 10011, which includes a total of five bits. Herein, Lmax = 4. That is, L = 4. If a binary bit of a data sequence to be sent by the transmit side is 101011, which includes a total of six bits, the message polynomial is M(D) = D^5 + D^3 + D + 1. Herein, ^ represents an exponential operation. Further, it can be learned that M(D) * D^5 = D^9 + D^7 + D^5 + D^4. A corresponding binary information bit obtained by dividing a binary bit 1010110000 corresponding to M(D) * D^5 by the polynomial gCRCLmax is 10011. That is, an L-bit remainder is obtained based on a modulo-2 algorithm. In this example, a bit sequence of the remainder is 0100, and the remainder is the check bit. Therefore, a bit stream of a CRC codeword obtained through CRC encoding is 1010110100. First 6 bits are original data 9 (namely, the information bit), and last 4 bits are the check bit. The transmit side may perform subsequent processing on the bit stream 1010110100 and send the bit stream. If no error occurs in a data transmission process, data that includes the check bit and that is received by the receive side can be exactly divided by the binary bit 10011 of the generator polynomial of the check bit. If an error occurs in a transmission process, data that includes the check bit and that is received by the receive side cannot be exactly divided by 10011. In this way, the receive side can identify a transmission error.

In embodiments of this application, a network device and a terminal device may be used as a transmit side and a receive side respectively. For example, in downlink communication, the network device is a transmit side, and the terminal device is a receive side; and in uplink communication, the terminal device is a transmit side, and the network device is a receive side. The network device may be a transmit side or a receive side. If the transmit side is a network device, the receive side is a terminal device. In this case, downlink communication is performed. If the transmit side is a terminal device, the receive side is a network device. In this case, uplink communication is performed. In addition, in this application, a case in which both the transmit side and the receive side are terminal devices is not excluded. In this case, D2D communication is performed between the transmit side and the receive side.

(3) Code rate (code rate)

The code rate is also referred to as an encoding rate or encoding efficiency, and is a proportion of a useful (non-redundant) part in a data stream. In other words, if the code rate is k/n and a unit is bit/symbol, an encoder generates n-bit data in total for every k bits of useful information, where n - k is redundant. If R is a total bit rate or a data signaling rate (including redundancy error encoding), a net bit rate (a useful bit rate excluding error correction code) is less than or equal to R * k/n. This means that, excluding the error correction code, the encoding rate is 1 and the total bit rate or the data signaling rate is equal to the net bit rate or the useful bit rate.

(4) Rate matching (rate matching)

A data block existing before encoding is referred to as a transport block (transport block, TB). Because a TB has a large quantity of bits, a transmit side usually splits one TB into a plurality of code blocks (code block, CB), and channel encoding is separately performed on each CB. Because a physical resource for transmitting a code block may be inconsistent with a physical time-frequency resource of a to-be-transmitted code block, bit retransmission or puncturing needs to be performed for the to-be-transmitted code block, to match a bearing capability of the physical time-frequency resource. This process is referred to as rate matching (rate matching). For a plurality of CBs on which channel encoding is performed, rate matching needs to be performed, and then processing such as interleaving and concatenation is performed. Then, the plurality of CBs are used as one physical data block (codeword) and are transmitted to a receive side.

The following describes the technical solutions in this application with reference to specific embodiments.

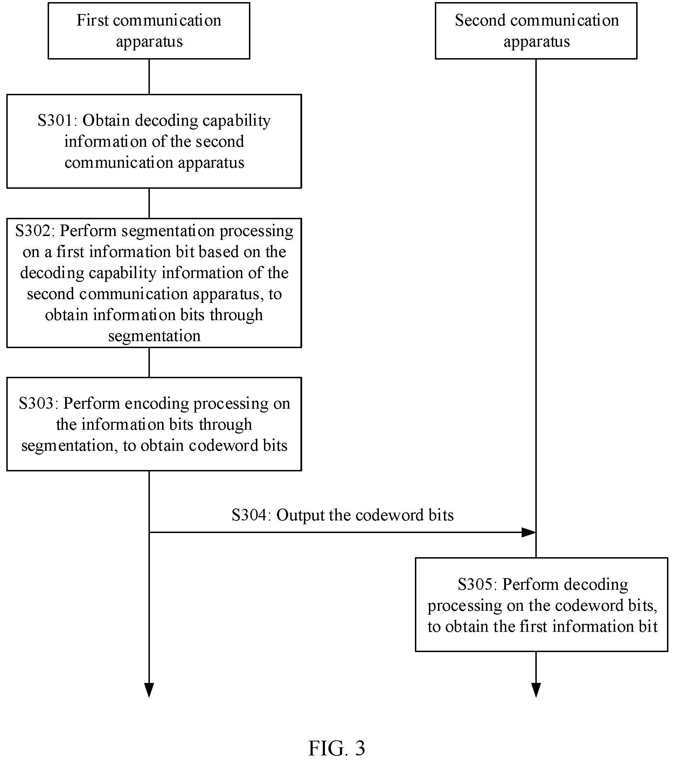

Embodiments of this application provide a data processing method. The method may be applied to but is not limited to the communication system shown in FIG. 1. The method may be implemented by a first communication apparatus and a second communication apparatus. The first communication apparatus may be used as a transmit side and/or a receive side of data, and the second communication apparatus may also be used as a transmit side and/or a receive side of the data. In other words, if the first communication apparatus is used as a transmit side, the second communication apparatus is a receive side; or if the first communication apparatus is used as a receive side, the second communication apparatus is a transmit side. The method may be performed by the first communication apparatus or the second communication apparatus, or may be performed by a component (a module, a chip, or the like) corresponding to the first communication apparatus or the second communication apparatus, or may be performed by an apparatus that is correspondingly used together with the first communication apparatus or the second communication apparatus. Specific forms and quantities of the first communication apparatus and the second communication apparatus are not specifically limited in embodiments of this application. Refer to FIG. 3. A specific procedure of the method is as follows.

S301: The first communication apparatus obtains a first information bit and decoding capability information of the second communication apparatus.

In this embodiment of this application, the first communication apparatus may be but is not limited to a network device or a terminal device.

In this embodiment of this application, the information bit may be a bit carrying information. In the foregoing, the first information bit may be referred to as a to-be-transmitted payload information bit or an original information bit.

In an implementation, that the first communication apparatus obtains the decoding capability information of the second communication apparatus may be implemented in but is not limited to the following manners:

Manner 1: Receive first information from the second communication apparatus, where the first information indicates the decoding capability information of the second communication apparatus.

Manner 2: Receive capability information of the second communication apparatus from the second communication apparatus, where a first field in the capability information of the second communication apparatus indicates the decoding capability information of the second communication apparatus.

Manner 3: Receive type information of the second communication apparatus from the second communication apparatus, where the type information of the second communication apparatus includes the decoding capability information of the second communication apparatus.

In this embodiment of this application, the decoding capability information of the second communication apparatus is a maximum length $N_{max}$ that is of a codeword and that is supported by the second communication apparatus for decoding, and $N_{max}$ is a value greater than 0. Alternatively, the decoding capability information of the second communication apparatus is a minimum code rate $R_{min}$ that is of the codeword and that is supported by the second communication apparatus for decoding. Then, a maximum length $N_{max}$ that is of the codeword and that is supported by the second communication apparatus for decoding may be obtained through calculation according to a formula $N_{max} = A/R_{min}$.

For example, a base station (an encoder side/a transmit side) may set several levels (or several tiers) based on a UE decoding capability. For example, a plurality of decoding capabilities are $N_{max(0)}$, $N_{max(1)}$, $N_{max(2)}$, ..., and $N_{max(J-1)}$, and corresponding level numbers j are 0, 1, 2, ..., and J - 1. A UE 1 may report, to the base station, that a level number j of the UE 1 is 1. In this case, the base station may determine, based on the level number 1 of the UE 1, that a maximum length that is of a codeword and that is supported by the UE 1 for decoding is $N_{max(1)}$.

S302: The first communication apparatus performs segmentation processing on the first information bit based on the decoding capability information of the second communication apparatus, to obtain information bits through segmentation.

In this embodiment of this application, when the first communication apparatus performs step S302, implementations may include but are not limited to the following.

**Implementation** 1: The first communication apparatus may perform segmentation processing based on a code rate, the first information bit, and the maximum length $N_{max}$ that is of the codeword and that is supported by the second communication apparatus for decoding.

In a possible implementation, the first communication apparatus may determine an initial segmentation value C' based on a quantity L of bits of cyclic redundancy check CRC concatenated to each segment, the code rate, $N_{max}$, and a quantity of bits of the first information bit, where L is a preset integer greater than or equal to 0, and C' is an integer greater than or equal to 1;

if the code rate is greater than or equal to a preset code rate, determine that a segment quantity is equal to the initial segmentation value C'; and

if the code rate is less than the preset code rate, determine that the segment quantity is equal to C1, where C1 is a positive integer less than or equal to C'.

In some embodiments, if it is obtained through calculation that the initial segmentation value C' = 1, when the code rate is less than the preset code rate, the segment quantity C1 = C' = 1.

For example, the initial segmentation value C' may satisfy the following formula:

$$C' = \left\lceil \frac{A}{K_{cb} - L} \right\rceil \text{ Formula (1)}$$

Herein, $K_{cb}$ is a maximum value of a quantity of information bits of each segment obtained through segmentation, $K_{cb} = \lceil R \times N_{max} \rceil$, $R$ is the code rate, A is a quantity of bits of the first information bit, $\lceil \rceil$ is a ceiling symbol, and / is a division sign.

In the foregoing, a value of the preset code rate is greater than 0 and less than 1. For example, the preset code rate is equal to 1/4, $C1 = \lceil C' / y \rceil$, and y is an integer greater than or equal to 1. For example, y is equal to 2.

In this embodiment of this application, an encoding gain corresponding to a code rate less than 1/4 is close to an energy gain of repeated sending. Therefore, when the code rate is less than 1/4, previous codeword bits are directly repeatedly sent, to reduce encoding operations and obtain the energy gain of repeated sending.

In Formula (1), it is considered that each segment of information bits is concatenated with L-bit CRC. Therefore, $K_{cb}$ includes an information bit and a check bit. When there is no concatenated L-bit CRC, Formula (1) may be changed to

$$C' = \left\lceil \frac{A}{K_{cb}} \right\rceil,$$ where is $K_{cb}$ a number obtained through rounding.

Further, when the segment quantity is equal to C', a quantity of bits A' = C' · $K_{cb}$ of an updated first information bit may be obtained through calculation, and then the first communication apparatus evenly divides A' into C' segments. When the segment quantity is equal to C1, a quantity of bits A' = C1 · $K_{cb}$ of the updated first information bit may be obtained through calculation, and then the first communication apparatus evenly divides A' into C1 segments.

This implementation may be applied to a case in which the first communication apparatus needs to perform segmentation processing on the first information bit, for example, the quantity of bits of the first information bit is greater than $K_{cb}$($K_{cb}$ is a maximum quantity of bits of each segment of information bits) obtained through calculation.

In another possible implementation, the first communication apparatus determines that a segmentation component is equal to 1, that is, the first communication apparatus directly performs encoding processing on the first information bit, and then sends the first information bit to the second communication apparatus.

**Implementation 2:** The first communication apparatus may perform segmentation processing based on a total quantity of transmission resource units, a modulation order, the first information bit, and the maximum length $N_{max}$ that is of the codeword and that is supported by the second communication apparatus for decoding, where $N_{max}$ is a value greater than 0.

Specifically, the following is included: first determining an initial segmentation value $C_3$ based on the total quantity of transmission resource units, the modulation order, and the maximum length $N_{max}$ that is of the codeword and that is supported by the second communication apparatus for decoding, where $C_3$ is a positive integer; and then calculating a quantity of bits of a remaining transmission resource based on the total quantity of transmission resource units, the modulation order, the initial segmentation value $C_3$, and the maximum length $N_{max}$ that is of the codeword and that is supported by the second communication apparatus for decoding; and

if the quantity of bits of the remaining transmission resource is less than a preset value, determining that the segment quantity is equal to $C_3$, where when the segment quantity is equal to $C_3$, the first communication apparatus may evenly divide the first information bit into $C_3$ segments; and

if the quantity of bits of the remaining transmission resource is not less than the preset value, determining that the segment quantity is equal to $C_3$ + 1, where when the segment quantity is equal to $C_3$ + 1, the first communication apparatus may evenly divide the first information bit into $C_3$ + 1 segments.

For example, the initial segmentation value $C_3$ may satisfy Formula (2):

$$C_3 = \lfloor Q_m \times E_{total} / N_{max} \rfloor \text{ Formula (2)}$$

The quantity of bits of the remaining transmission resource may satisfy Formula (3):

$$B_{rest} = E_{total} \times Q_m - C_3 \times N_{max} \text{ Formula (3)}$$

The segment quantity C may satisfy Formula (4):
when

$$B_{rest} < z \cdot N_{max}, C = C_3;$$

or
when

$$B_{rest} \geq z \cdot N_{max}, C = C_3 + 1 \quad \text{Formula (4)}$$

Herein, $Q_m$ is the modulation order, $E_{total}$ is the total quantity of transmission resource units, $B_{rest}$ is the quantity of bits of the remaining transmission resource, $z \cdot N_{max}$ is the preset value, z is a value greater than 0 and less than 1, $\lfloor \rfloor$ is a floor symbol, and / is a division sign.

In this embodiment of this application, a conversion formula between a quantity of remaining transmission resource units $E_{rest}$ and the quantity of bits $B_{rest}$ of the remaining transmission resource may be: $E_{rest} = B_{rest}/Q_m$.

For example, z = 9/16 and $B_{rest} < \frac{9}{16} \cdot N_{max}$. It can be learned that the quantity of bits of the remaining transmission resource is less than half of $N_{max}$, that is, the quantity of remaining transmission resource units is small. Therefore, in comparison with the initial segmentation value $C_3$, no more transmission resource units can be allocated, and the remaining transmission resource units may be used for subsequent retransmission.

When $B_{rest} \geq \frac{9}{16} \cdot N_{max}$. $N_{max}$, it can be learned that the quantity of bits of the remaining transmission resource is greater than half of $N_{max}$, that is, the quantity of remaining transmission resource units is large, a segment quantity may be one more (that is, one additional segment can be obtained through division) than the initial segmentation value $C_3$, and the remaining transmission resource units may be used to transmit the additional segment of codeword bits obtained through division.

In this embodiment of this application, a value of z may be $\frac{9}{16}$, and it can be ensured that a quantity of bits removed through rate matching (for example, a quantity of bits removed through shortening (shortening) or puncturing (puncturing)) is less than half of a mother code length.

S303: The first communication apparatus performs encoding processing on the information bits obtained through segmentation, to obtain the codeword bits.

Based on Implementation 1: When the first communication apparatus performs step S303, the following may be included: concatenating a segment of CRC with a quantity of L bits at a tail of each segment of information bits obtained through segmentation, to obtain each segment of concatenated information bits; and then encoding each segment of concatenated information bits, to obtain each segment of codeword bits.

Specifically, when the segment quantity is equal to C', the first communication apparatus may concatenate L-bit CRC after each segment of information bits in the C' segments of information bits obtained through segmentation; and then, perform encoding processing on each segment of concatenated information bits.

When the segment quantity is equal to C1, L-bit CRC is concatenated after each segment of information bits in the C1 segments of information bits; and then, encoding processing is performed on each segment of concatenated information bits.

When the segmentation component is equal to 1, the first communication apparatus may directly perform encoding processing on the first information bit, without concatenating CRC.

Based on Implementation 2: When the first communication apparatus performs step S303, the following may be included:

When the segment quantity is equal to $C_3$, the first communication apparatus may concatenate L-bit CRC after each segment of information bits in the $C_3$ segments of information bits obtained through segmentation, and then perform encoding processing on each segment of concatenated information bits. In this case, a size of each codeword bit in the $C_3$ segments of codeword bits is equal to the maximum length $N_{max}$ that is of the codeword and that is supported for decoding, and code rates of all segments in the $C_3$ codeword bits are the same.

When the segment quantity is equal to $C_3$ + 1, the first communication apparatus may concatenate L-bit CRC after each segment of information bits in the $C_3$ segments of information bits obtained through segmentation, and then perform encoding processing on each segment of concatenated information bits.

When the segment quantity is $C_3$ + 1, in comparison with the initial segmentation value $C_3$, one additional segment is obtained by dividing the first information bit. Therefore, in comparison with a quantity of bits of each segment of information bits obtained through division based on the initial segmentation value, a quantity of bits of each segment of information bits (namely, original information bits) in first $C_3$ segments is reduced, and a size of the first $C_3$ segments of codeword bits is equal to the maximum length $N_{max}$ that is of the codeword and that is supported by the second communication apparatus for decoding, so that a code rate of each segment in the first $C_3$ segments is slightly reduced. Because a size of a last segment of codeword bits is smaller than $N_{max}$, a code rate corresponding to the last segment is large.

S304: The first communication apparatus outputs the codeword bits. Correspondingly, the second communication apparatus obtains the codeword bits.

In this embodiment of this application, the first communication apparatus may send the codeword bits to the second communication apparatus via a component (for example, a communication module or an antenna) in the first communication apparatus; or the first communication apparatus may output the codeword bits through a communication interface of the first communication apparatus, and correspondingly, the second communication apparatus obtains the codeword bits through a communication interface; or the first communication apparatus may output the codeword bits via a component (for example, a chip) corresponding to the first communication apparatus, and correspondingly, the second communication apparatus obtains the codeword bits via a component (for example, a chip) corresponding to the second communication apparatus. Therefore, a specific implementation in which the first communication apparatus transmits the codeword bits to the second communication apparatus is not limited in this application.

For example, a DU (equivalent to the first communication apparatus) of a base station sends codeword bits to a UE (equivalent to the second communication apparatus).

Based on Implementation 1: When the first communication apparatus performs S304, the following may be included:

When the segment quantity is C', the first communication apparatus may send the C' segments of codeword bits to the second communication apparatus via total pre-allocated transmission resource units.

In embodiments of this application, time domains in which the first communication apparatus sends the C' segments of codeword bits may be the same or may be different. This is not specifically limited.

When the segment quantity is C1, the first communication apparatus may transmit the C1 segments of codeword bits via the pre-allocated total transmission resource units. If a quantity of transmission resource units occupied for sending the C 1 segments of codeword bits is less than a total quantity of transmission resource units, the first communication apparatus may retransmit a part of codeword bits or all of codeword bits in the C1 segments of codeword bits via a remaining transmission resource unit in the total transmission resource units.

In some embodiments, in the foregoing, the codeword bits that are the part of the C1 segments of codeword bits and that are retransmitted by the first communication apparatus may be codeword bits in a complete segment part, or may be codeword bits in an incomplete segment part.

For example, the first communication apparatus retransmits C2 segments of codeword bits in the C1 segments of codeword bits , where C2 is a positive integer value less than or equal to C1.

For another example, the first communication apparatus retransmits C2 segments of codeword bits in the C1 segments of codeword bits, where C2 is a non - integer value greater than 0 and less than C1.

In embodiments of this application, the retransmitted codeword bits may alternatively be repeated bits sequentially from front to back in a codeword.

For example, a quantity C1 of segments of an encoded codeword is 3, and bits repeatedly sent are $1^{st}$, $2^{nd}$, $3^{rd}$, ..., and $N_{rep}^{th}$ bits in a first segment, where $N_{rep}$ is a quantity of codeword bits repeatedly sent. When $N_{rep}$ is less than a length of the codeword segment, transmission continues until a quantity of bits allowed to be carried by remaining transmission resources is reached. When $N_{rep}$ is greater than the length of the codeword segment, sending continues from beginning of a second codeword segment, and so on, until all remaining transmission resources are used up.

For another example, a quantity C1 of segments of the encoded codeword is 1, namely, one segment. If the retransmitted bits are $1^{st}$, $2^{nd}$, $3^{rd}$, ..., and $N_{rep}^{th}$ bits in the segment, $N_{rep}$ represents a quantity of repeatedly sent codeword bits. When $N_{rep}$ is greater than the length of the codeword segment, transmission continues from beginning in a loop. When $N_{rep}$ is less than the length of the codeword segment, repeated transmission continues until a quantity of bits allowed to be carried by remaining transmission resources is reached.

In some other embodiments, if there is still a remaining transmission resource unit in remaining transmission resource units after the first communication apparatus retransmits the C1 segments of codeword bits via the remaining transmission resource units, the remaining transmission resource unit may be continually used to retransmit a part of codeword bits or all of codeword bits in the C1 segments of codeword bits. For a specific retransmission situation, refer to the foregoing retransmission situation. Details are not described herein again.

Based on Implementation 2: When the first communication apparatus performs S304, the following may be included:

When the segment quantity is $C_3$, the first communication apparatus may transmit $C_3$ segments of codeword bits via total pre-allocated transmission resource units. If a quantity of transmission resource units occupied by the $C_3$ segments of codeword bits is less than a total quantity of transmission resource units, a part of codeword bits or all of codeword bits in the $C_3$ segments of codeword bits are retransmitted via a remaining transmission resource unit in the total transmission resource units, where $C_3$ is a positive integer.

In some embodiments, the codeword bits that are the part of the C3 segments of codeword bits and that are retransmitted by the first communication apparatus may be codeword bits of a complete segment part, or may be codeword bits of an incomplete segment part.

For example, the first communication apparatus retransmits C4 segments of codeword bits in the C3 segments of codeword bits , where C4 is a positive integer value less than or equal to C3.

For another example, the first communication apparatus retransmits C4 segments of codeword bits in the C3 segments of codeword bits, where C4 is a non - integer value greater than 0 and less than C3.

Specifically, refer to the retransmission manner illustrated in Implementation 1, and details are not described herein again.

When the segment quantity is $C_3 + 1$, the first communication apparatus may transmit first $C_3$ segments of codeword bits in the $C_3 + 1$ segments of codeword bits via the total pre-allocated transmission resource units. If the quantity of transmission resource units occupied by the first $C_3$ segments of codeword bits is less than the total quantity of transmission resource units, a last segment of codeword bits is transmitted via the remaining transmission resource unit in the total transmission resource units.

S305: The second communication apparatus performs decoding processing on the codeword bits, to obtain the first information bit.

Based on Implementation 1: The second communication apparatus receives C' segments of codeword bits from the first communication apparatus, where C' is an integer greater than or equal to 1. In this case, the first communication apparatus may first perform decoding processing on the C' segments of codeword bits, to obtain C' segments of concatenated information bits; and then remove CRC code from the C' segments of concatenated information bits, to obtain the first information bit.

The second communication apparatus receives, from the first communication apparatus, $C_1$ segments of codeword bits and codeword bits that are a part or all of the $C_1$ segments of codeword bits and that are retransmitted, where C1 is a positive integer less than or equal to C'. In this case, the second communication apparatus may first combine soft bits corresponding to the C1 segments of codeword bits and soft bits corresponding to the retransmitted codeword bits, and the perform decoding, to obtain the concatenated information bits; and then remove the concatenated CRC code from the concatenated information bits, to obtain the first information bit.

In embodiments of this application, the soft bit may refer to demodulated soft bit information LLR, and is also referred to as a log likelihood ratio (log likelihood ratio, LLR).

For example, the UE 1 receives three codewords, which are a codeword 1, a codeword 2, a codeword 3, and a codeword 4 respectively, and the UE 1 further receives the retransmitted codeword 1, the retransmitted codeword 2, and the retransmitted codeword 3. The UE 1 combines (concatenates) soft bits corresponding to the codeword 1 and soft bits corresponding to the retransmitted codeword 1 and performs decoding, combines (concatenates) soft bits corresponding to the codeword 2 and soft bits corresponding to the retransmitted codeword 2 and performs decoding, combines (concatenates) soft bits corresponding to the codeword 3 and soft bits corresponding to the retransmitted codeword 3 and performs decoding, and separately decodes soft bits corresponding to the codeword 4; and then, removes CRC bits from each segment of decoded information bits.

In some embodiments, when the second communication apparatus receives $C_1$ segments of codeword bits and retransmitted $C_1$ ($C_2=C_1$) segments of codeword bits, and further receives codeword bits that are a part or all of the $C_1$ segments of codeword bits and that are retransmitted for a second time, the second communication apparatus performs combining and decoding with reference to the foregoing manner. Details are not described herein again.

Based on Implementation 2: The second communication apparatus receives, from the first communication apparatus, the $C_3$ segments of codeword bits and the codeword bits that are the part or all of the $C_3$ segments of codeword bits and that are retransmitted. In this case, the second communication apparatus may first combine the soft bits corresponding to the $C_3$ segments of codeword bits and the soft bits corresponding to the retransmitted codeword bits, and then perform decoding, to obtain the concatenated information bits; and then remove the CRC code from the concatenated information bits, to obtain the first information bit. For a specific example, refer to the foregoing manner to perform combining and decoding. Details are not described herein again.

The second communication apparatus receives $C_3 + 1$ segments of codeword bits from the first communication apparatus, where $C_3$ is a positive integer. In this case, the second communication apparatus may first perform decoding processing on the $C_3 + 1$ segments of codeword bits, to obtain $C_3 + 1$ segments of concatenated information bits; and remove the CRC code from the $C_3 + 1$ segments of concatenated information bits, to obtain the first information bit.

In this embodiment of this application, a size of first $C_3$ segments of codeword bits in $C_3 + 1$ is equal to the maximum length $N_{max}$ that is of the codeword and that is supported by the second communication apparatus for decoding, and code rates of the first $C_3$ segments of codeword bits in $C_3 + 1$ are slightly reduced. However, a length of a last segment of codeword bits in $C_3 + 1$ is less than $N_{max}$, and therefore a code rate is large.

In this embodiment of this application, when the segment quantity is 1, that is, segmentation processing is not performed on the first information bit, the second communication apparatus receives the codeword bits, and the codeword bits are data obtained by directly performing encoding processing on the first information bit by the second communication apparatus. Therefore, the second communication apparatus may perform decoding processing on the codeword bits, to obtain the first information bit.

It should be noted that the solution in FIG. 3 in this embodiment of this application may be applied to the transmission procedure shown in FIG. 2, and a channel encoding process and a channel decoding process are mainly described in detail. The solution in FIG. 3 in this embodiment of this application further includes another process (for example, modulation) in the transmission procedure. For a specific implementation procedure, refer to an implementation procedure in the conventional technology. Details are not described herein again.

In conclusion, embodiments of this application provide a data processing method and apparatus. The method includes: The first communication apparatus first obtains the decoding capability information of the second communication apparatus; then performs segmentation processing on the first information bit based on the decoding capability information of the second communication apparatus, to obtain the information bits through segmentation; then performs encoding processing on the information bits obtained through segmentation, to obtain the codeword bits; and finally outputs the codeword bits. In the method, the first communication apparatus performs segmentation processing on the first information bit based on the decoding capability information of the second communication apparatus, to obtain the information bits through segmentation, then encodes the information bits obtained through segmentation, to obtain the codeword bits, and outputs the codeword bits to the second communication apparatus. This can ensure performance of the second communication apparatus in performing decoding.

Based on the data processing method shown in FIG. 3, the following provides detailed explanations through several specific embodiments.

**Embodiment** 1:

In Embodiment 1, an example in which a first communication apparatus is a base station and a second communication apparatus is UE 1 is used to describe in detail Implementation 1 of segmentation processing in step S302 in the solution in FIG. 3.

First, the base station obtains a maximum code length that can be supported by the UE 1, and determines a current code rate. Then, the base station performs even segmentation on a quantity of bits of a target payload (equivalent to the first information bit in the solution in FIG. 3) based on the maximum code length that can be supported by the UE 1 and the current code rate. Further, the base station concatenates an L-bit CRC code after each segment. For a subsequent procedure, refer to the encoding processing procedure shown in FIG. 2. For example, after concatenating the CRC code after each segment of data, the base station performs subsequent channel encoding and modulation, and then sends the data to the UE 1 through a channel. For a specific implementation, refer to the conventional technology. Details are not described herein again.

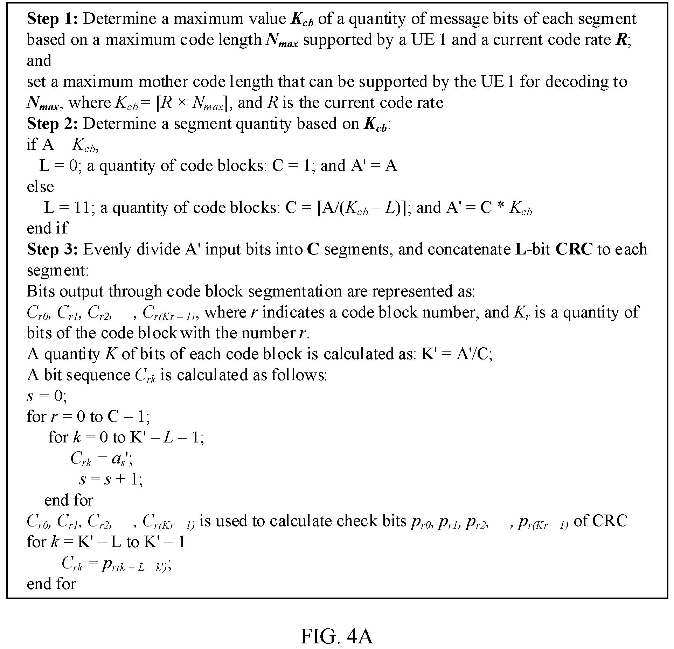

For example, FIG. 4A is a flowchart of performing segmentation processing and CRC encoding based on a maximum code length supported by a UE 1 and a current code rate. Refer to FIG. 4A. Specific explanations of the procedure are as follows.

Step 1: Determine a maximum value $K_{cb}$ of a quantity of message bits of each segment based on the maximum code length $N_{max}$ supported by the UE 1 and the current code rate R, where

$K_{cb}$ satisfies the following formula:

$$K_{cb} = \lceil R \times N_{max} \rceil.$$

Step 2: Determine a segment quantity based on $K_{cb}$.

Case 1: If a quantity of bits of a target payload is not greater than the maximum value of the quantity of bits of each segment of message bits ($A \le K_{cb}$), a quantity L of bits of CRC is 1, a quantity C of code blocks (namely, the segment quantity) is 1, and a quantity A' of to-be-segmented payload bits is equal to the quantity A of bits of the target payload.

Case 2: Otherwise, that is, the quantity of bits of the target payload is greater than the maximum value of the quantity of bits of each segment of message bits, the quantity L of bits of the CRC is 11, and the quantity C of code blocks (namely, the segment quantity) and the quantity of to-be-segmented payload bits A' are obtained through calculation according to the following formula:

$$C = \lceil A/(K_{cb} - L) \rceil;$$

and

$$A' = C \cdot K_{cb}.$$

Step 3: Evenly divide the A' input bits obtained in step 2 into C segments, and concatenate L-bit L CRC to each segment.

For a case in which the segment quantity is not 1, that is, $C = \lceil A/(K_{cb} - L) \rceil$, the quantity A' of payload bits are first divided into C segments (namely, C code blocks), and then a segment of L-bit CRC is concatenated at a tail of each segment.

For example, r represents a sequence number corresponding to a code block, a value of r ranges from 0 to C - 1, and $K_r$ is a quantity of bits of the code block with the sequence number r. The quantity $K_r$ of bits of the code block r is calculated as follows: K' = A'/C. The bits of the code block $r$ are represented as $C_{r0}, C_{r1}, C_{r2}, \ldots, C_{r(K_r}1)$.

Refer to a cyclic formula for calculating a bit sequence $C_{rk}$ shown in FIG. 4A. It can be learned that, for the code block with the sequence number r, a corresponding bit sequence is as follows:

when

$$k = 0, \ C_{r0} = a'_0;$$

when

$$k = 1, \ C_{r1} = a'_1;$$

when

$$k = 2, \ C_{r2} = a'_2;$$

...; and
when

$$k = 0 \text{ to } K' - L - 1, \ C_{rK'-L-1} = a'_{K'-L-1}.$$

With reference to an existing CRC encoding technology, CRC bits are calculated according to $C_{r0}, C_{r1}, C_{r2}, \ldots, C_{r(K_r}1)$ as follows: $p_{r0}, p_{r1}, p_{r2}, \ldots, p_{r(L-1)}$.

Refer to FIG. 4A. L bits of CRC of the code block with the sequence number r are represented as follows:

$$C_{rk} = p_{r(k+L-K')},$$

where
a value of k ranges from K' - L to K' - 1.

When the segment quantity is equal to 1, that is, C = 1, the quantity A' of bits of the payload are determined as a code block. Bits of the code block may be represented as the bit sequence $C_{rk}$ in the foregoing manner.

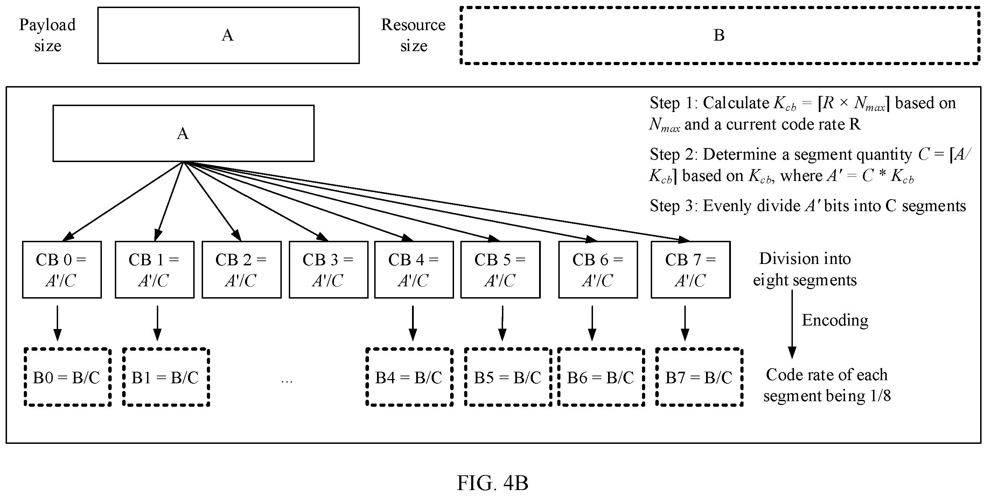

For example, FIG. 4B shows the segmentation-based transmission mode in Embodiment 1, that is, when the current code rate R is not less than a preset threshold (for example, $\frac{1}{4}$), segmentation is performed based on a determined segment quantity, a quantity of bits of each segment is A'/C, and a size of a physical resource occupied by each segment is equal to E/C. A code rate of each segment is A/E. E indicates a total quantity of physical resources allocated by the base station for transmission, in a unit of bit (bit).

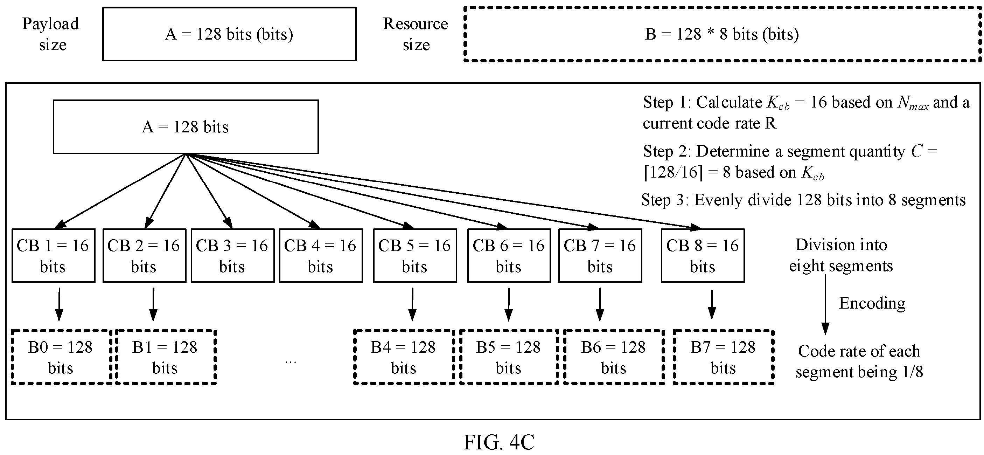

For example, a total payload size of a message is A = 128 bits, B = 1024 bits, a maximum decoding length supported by a decoder of the UE 1 is $N_{max}$ = 128, and the current code rate is $R = \frac{1}{8}$, it is obtained through calculation that $K_{cb}$ = quantity $C = \lceil A/(K_{cb} - L) \rceil = \lceil 128/16 \rceil = 8$ is obtained through calculation according to $K_{cb}$ = 16 bits, and a size of a resource occupied by each segment is 128 bits, as shown in FIG. 4C.

**Embodiment 2:**

In Embodiment 2, based on the further description of the solution in Embodiment 1, that is, when the current code block is less than the preset value (for example, $\frac{1}{4}$), segmentation processing is performed based on half of the segment quantity in step 1, and a remaining resource may be used for retransmission.

Step 1: Determine a maximum value $K_{cb}$ of a quantity of message bits of each segment based on a maximum decoding code length $N_{max}$ supported by a decoder of the UE 1 and a current code rate $R$.

Step 1 may be implemented with reference to step 1 in Embodiment 1, and details are not described herein again.

Step 2: Determine a segment quantity to be C based on $K_{cb}$.

When the current code rate $R < \frac{1}{4}$, a quantity C' of initial code blocks (equivalent to the initial segmentation value in the solution in FIG. 3) is first determined with reference to the manner in step 2 in Embodiment 1 as follows:

$$C' = \lceil A/(K_{cb} - L) \rceil.$$

Then, it is determined that an actual segment quantity is $C = \frac{C'}{2}$; and further, it is determined that a quantity of to-be-segmented payload bits is A' = C · $K_{cb}$.

Step 3: Evenly divide the A' input bits obtained in step 2 into C segments, and concatenate L-bit L CRC to each segment.

Step 3 is implemented with reference to step 3 in Embodiment 1, and details are not described herein again.

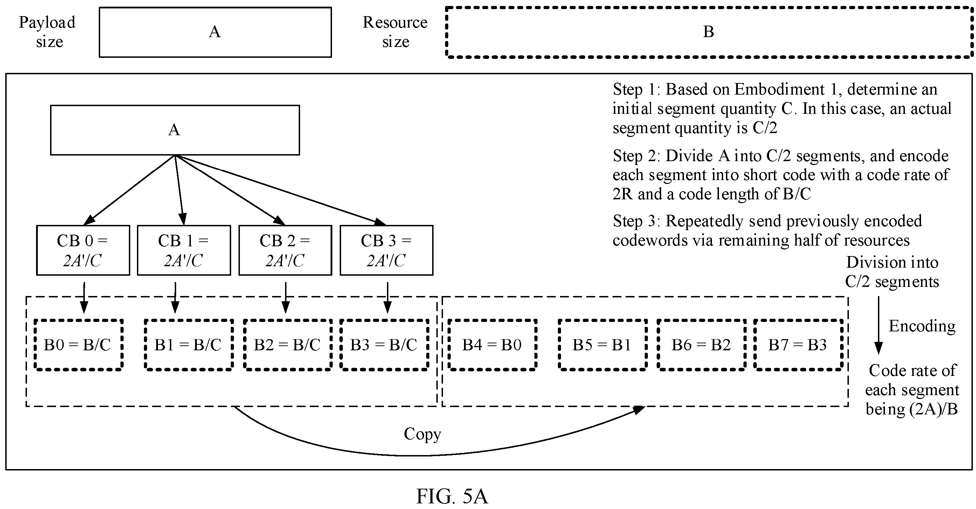

In Embodiment 2, if the current code rate $R$ is lower than the preset threshold (for example, $\frac{1}{4}$), the initial segment quantity C' is first determined based on the segmentation manner in Embodiment 1, and then half of the initial segment quantity is used as an actual segment quantity, that is, C = C'/2. A is evenly divided into C segments, each segment is encoded to have a code rate 2R, a code length of each segment is E/C, and the remaining resource may be used to retransmit the C segments, as shown in FIG. 5A.

For example, A = 128 bits, a quantity of bits of total transmission resources is B = E $\times$ $Q_m$ = 1024 bits, and the maximum decoding length supported by the decoder of the UE 1 is $N_{max}$ = 128 bits.

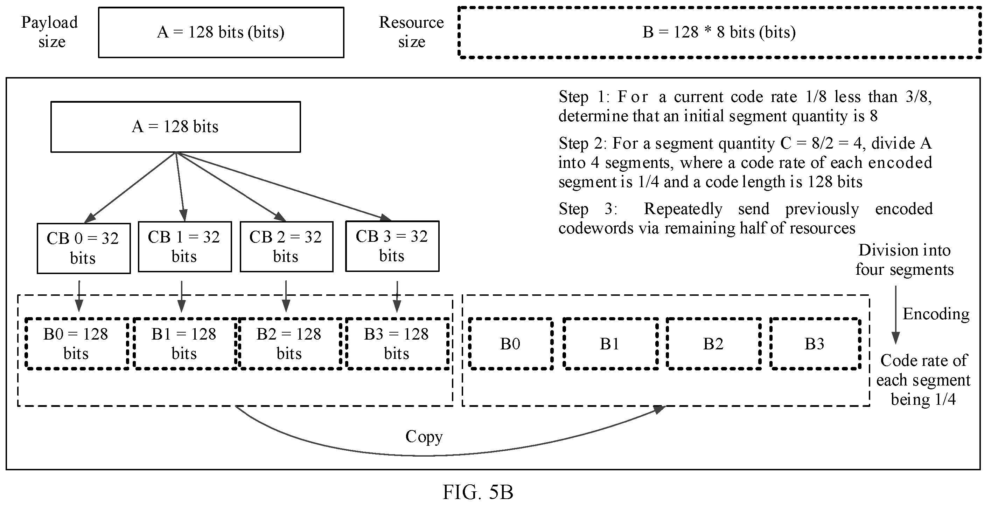

The current code rate is $R = \frac{A}{E} = \frac{1}{8} < \frac{1}{4}$. First, it is obtained through calculation according to Formula 1 in Embodiment 1 that C' = 8, that is, C = 4. Then, A is divided into four segments, each segment is encoded to have a code rate $2R = \frac{1}{4}$, a payload size of each segment is A/C = 128/4 = 32 bits, and a size of a resource occupied by each segment is 128 bits. A quantity of bits of the remaining resource is $B_{rest}$ = 1024 - 128 * 4 = 512 bits $B_{rest}$ = 1024 - $\times$ 4 = 512 bits, and the remaining resource is used to retransmit encoded codewords, as shown in FIG. 5B.

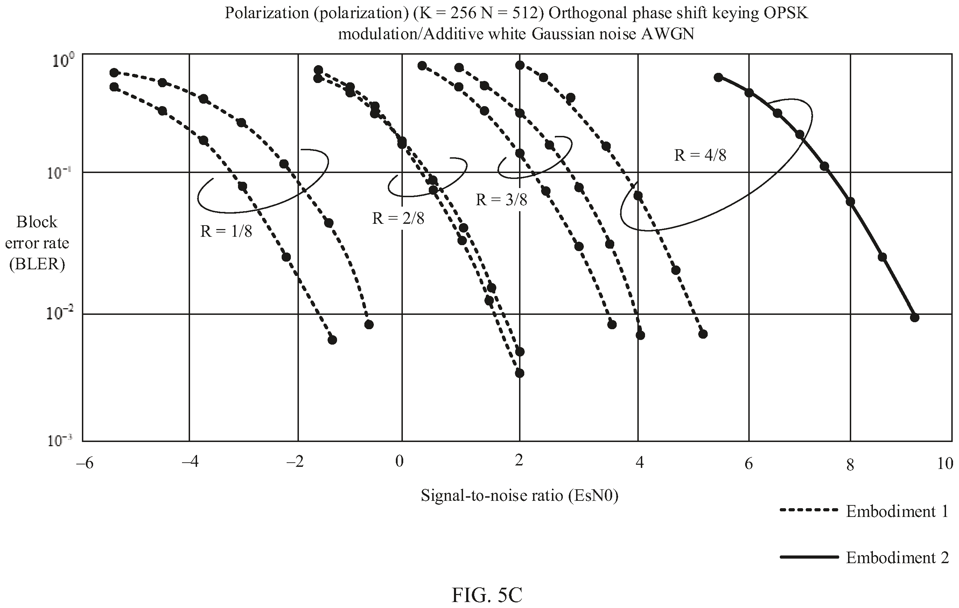

FIG. 5C shows decoding performance of segment quantities corresponding to Embodiment 1 and Embodiment 2 at different code rates. A horizontal axis is a signal-to-noise ratio (EsN0), and a unit is dB. A vertical axis is a block error rate (block error rate, BLER). Generally, a lower curve indicates better performance. It can be learned from FIG. 5C that, when the code rate is lower than the preset threshold $R_{th}$ = 1/4, performance of the segmentation manner in Embodiment 2 is better, and when the code rate is higher than the preset threshold $R_{th}$ = 1/4, performance of the segmentation manner in Embodiment 1 is better.

**Embodiment 3:**

In Embodiment 3, an example in which the first communication apparatus is a base station and the second communication apparatus is a UE 1 is used to describe in detail Implementation 2 of segmentation processing in step S302 in the solution in FIG. 3. First, the base station obtains a maximum code length supported by the UE 1 for decoding, and determines a total quantity of allocated transmission resource units. Then, the base station performs even segmentation on a quantity of bits of a target payload based on the maximum code length supported by the UE 1 for decoding and the total quantity of transmission resource units. Further, the base station concatenates L-bit CRC code after each segment. Refer to the encoding processing procedure shown in FIG. 2. After concatenating the CRC code after each segment of data, the base station performs subsequent channel encoding and modulation, and then sends the data to the UE 1 through a channel. For a specific implementation, refer to the conventional technology. Details are not described herein again.

The following is a procedure diagram of performing segmentation processing and CRC encoding based on the maximum code length supported by the UE 1 and the current code rate. The procedure is as follows:

Step 1: Determine a segment quantity C based on the maximum code length $N_{max}$ supported by the UE 1 and a current total quantity of resources $E_{total}$; and

determine a current modulation order $Q_m$.

First, an initial segment quantity $C_3$ (equivalent to $C_3$ in the solution in FIG. 3) is obtained through calculation as follows:

$$C_3 = \lfloor Q_m \times E_{total}/N_{max} \rfloor,$$

where $\lfloor \rfloor$ represents a floor operation.

Then, it is obtained through calculation that a quantity of bits of a remaining resource is $B_{rest} = E_{total} \times Q_m - C_3 \times N_{max}$.

If $B_{rest} < \dfrac{9}{16} N_{max}$ , it is determined that the segment quantity is C = $C_3$.

Otherwise, (that is, $E_{rest} \geq \dfrac{9}{16} N_{max}$ ), it is determined that the segment quantity C = $C_3$ + 1.

For example, a maximum mother code length supported by a decoder of the UE 1 is 128 bits, a modulation order $Q_m$ = 1, and $B_{total} = E_{total} \times Q$ = 260 bits.

$$C_3 = C_3 = \lfloor Q_m \times E_{total}/N_{max} \rfloor = \lfloor 2.0313 \rfloor = 2;$$

$$B_{rest} = B_{total} - C_3 \times N_{max} = 260 - 2 \times 128 = 4;$$

and $\dfrac{9}{16} N_{max} = \dfrac{9}{16} \times 128 = 72$ , where it can be learned that $B_{rest} < \dfrac{9}{16} N_{max}$ , and in this case,

$$C = C_3 = 2.$$

Because a quantity of remaining resources does not reach $\dfrac{9}{16}$ of the maximum mother code length supported by the decoder of the UE 1, segments obtained through division is reduced by one, the remaining resource is used to retransmit two segments of bit data.

For another example, the maximum mother code length supported by the decoder of the UE 1 is 128 bits, the modulation order $Q_m$ = 1, and $B_{total} = E_{total} \times Q_m$ = 360 bits.

$$C_3 = \lfloor Q_m \times E_{total}/N_{max} \rfloor = \lfloor 2.0313 \rfloor = 2;$$

$$B_{rest} = B_{total} - C_3 \times N_{max} = 360 - 2 \times 128 = 104;$$

and $\dfrac{9}{16} N_{max} = \dfrac{9}{16} \times 128 = 72$ , where it can be learned that $B_{rest} > \dfrac{9}{16} N_{max}$ , and in this case,

$$C = C_3 + 1 = 3.$$

Because the quantity of remaining resources is greater than the maximum mother code length $\dfrac{9}{16}$ supported by the decoder of the UE 1, one additional segment may be obtained through division. After $C_3$ segments are transmitted, the remaining resources are used to transmit a last segment.

Step 2: Determine a quantity of message bits of each segment to be $K' = \lceil A/C \rceil$ .

That is, the segment quantity C is determined based on step 1, and further, an A-bit target payload is evenly divided into C segments, where the quantity of bits of each segment is $K' = \lceil A/C \rceil$ , and $\lceil \rceil$ indicates a ceiling operation.

Then, a quantity of to-be-segmented payload bits is determined to be A' = C · K'.

Step 3: Evenly divide the A' input bits obtained in step 2 into C segments, and concatenate L-bit L CRC to each segment.

Step 3 may be implemented with reference to step 3 in Embodiment 1, and details are not described herein again.

**Embodiment 4:**

In Embodiment 4, how the first communication apparatus (namely, the transmit side or the encoder side) obtains the decoding capability of the second communication apparatus (namely, the receive side or the decoder side) in the solution in FIG. 3 is described. In this embodiment, an example in which the base station is used as an encoder side/a transmit side and the UE is used as a decoder side/a receive side is used. A quantity of base stations and a quantity of UEs are not specifically limited. For example, there may be a plurality of UEs. Refer to Table 1. Based on three protocols (38.306, 38.331, and 38.822) currently involved in a UE capability (UE Capability), the base station may obtain a decoding capability of each UE in the following several manners:

Manner 1: In the protocol 38.306, each UE capability and whether the UE capability is mandatory (UE Capability) are described in detail. Based on existing protocol content, an embodiment of this application proposes that a new field (field) may be added to indicate a UE decoding capability.

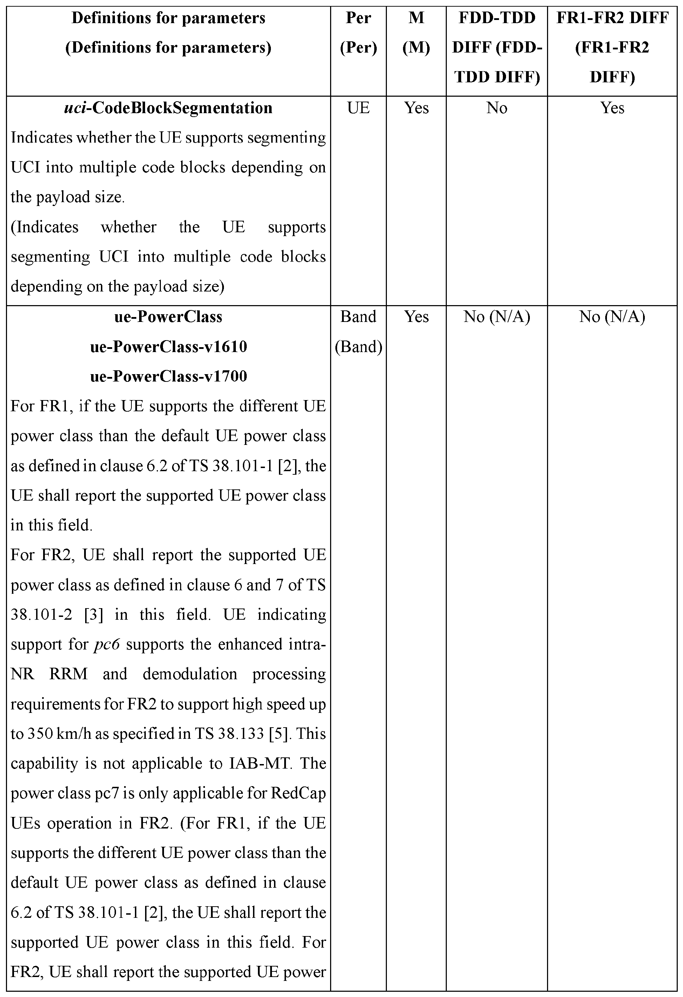

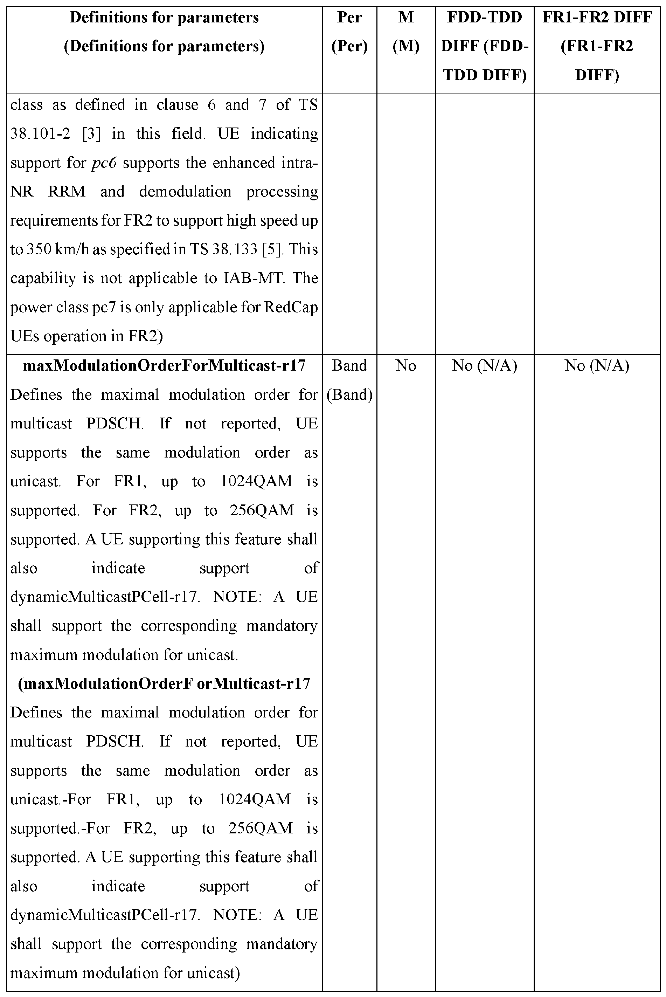

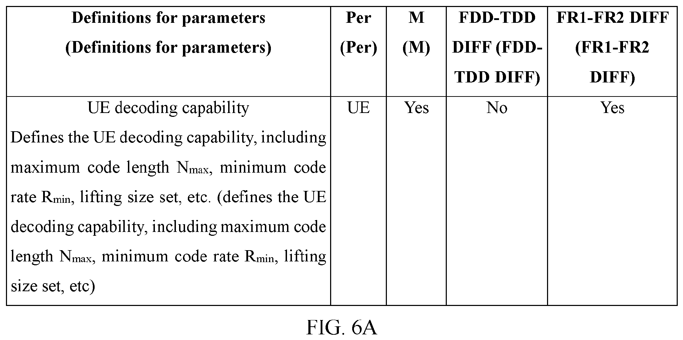

Refer to FIG. 6A. For example, a field is added to the chapter 38.306 4.2.7.10 phy-parameters to indicate the UE decoding capability. A bold part in FIG. 6A is new content.

Manner 2: A UE capability query and reporting procedure, a signaling structure, and the like are involved in the protocol 38.331. Based on existing protocol content, an embodiment of this application proposes that IEs may be added to indicate a maximum code length, a minimum code rate, and a maximum segment quantity that are supported by the UE for decoding.

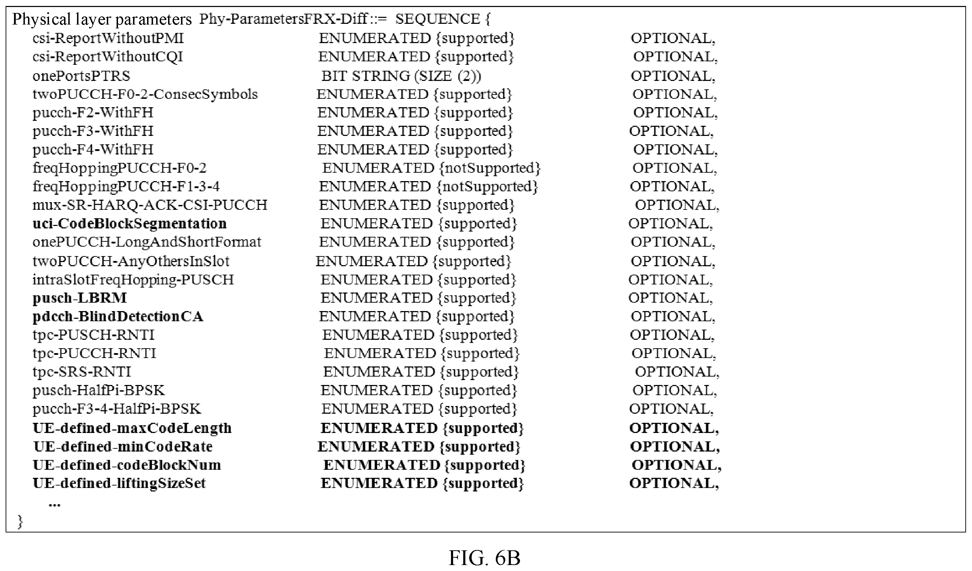

Refer to FIG. 6B. For example, the IEs are added to chapter 38.331 6.3.3 UE capability information elements to indicate the maximum code length, the minimum code rate, and the maximum segment quantity that are supported by the UE for decoding. A bold part in FIG. 6B is new content.

Manner 3: A UE feature (UE feature) is involved in the protocol 38.822, and the UE capability further translates the UE feature into a language required by the protocol. Based on existing protocol content, an embodiment of this application proposes that a feature of the UE decoding capability may be added. For example, components (Components) are added to NR_UE_pow_sav_enh, to indicate that to support low-power decoding, parameters such as the maximum code length $N_{max}$, the minimum code rate $R_{min}$, and a minimum segment quantity are limited.

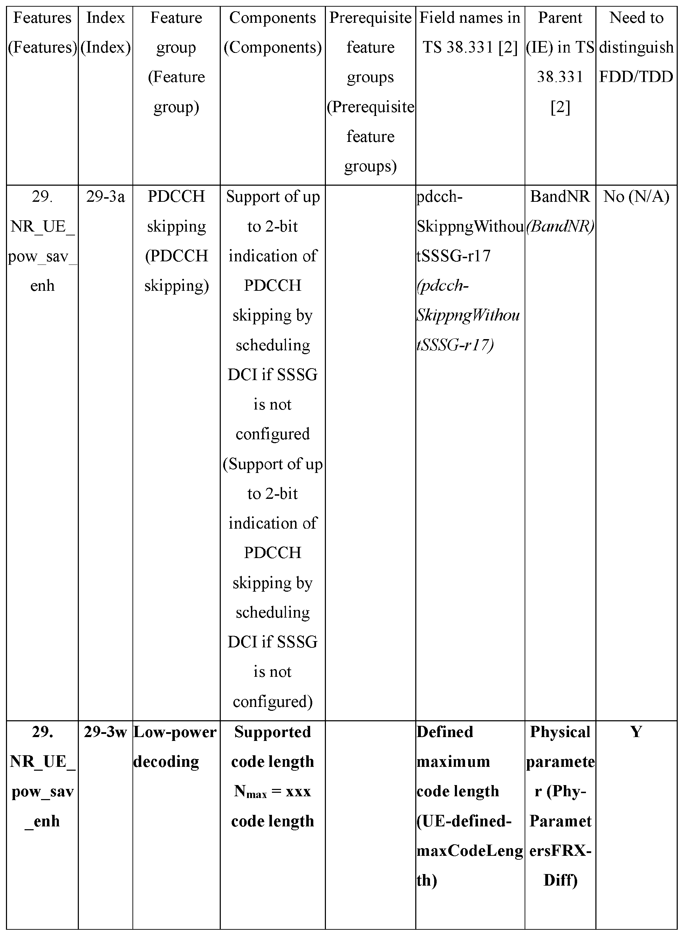

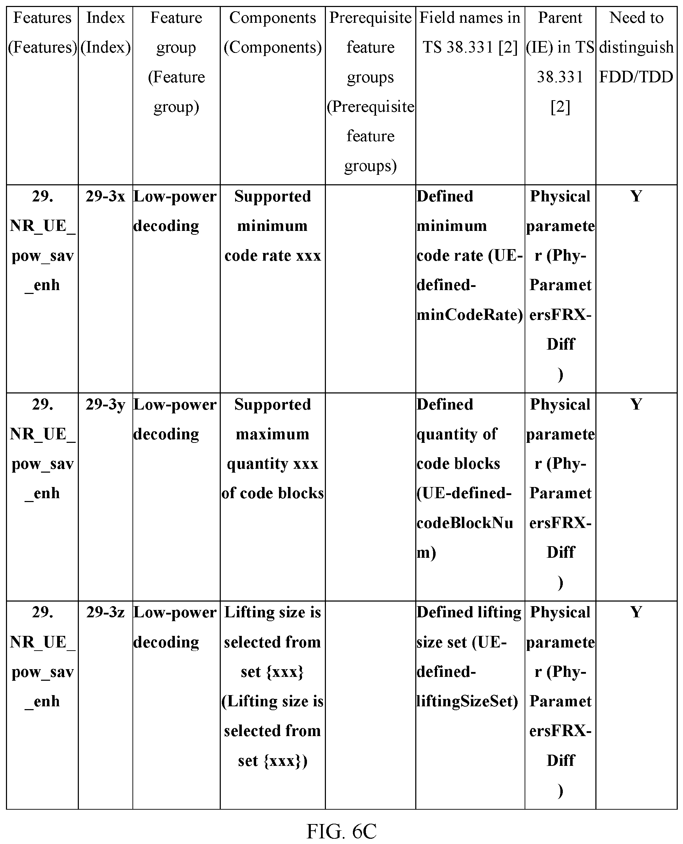

Refer to FIG. 6C. For example, the feature (feature) of the UE decoding capability is added to chapter 38.822 6.1 Layer-1 UE features, components are added to chapter 38.822 6.1.8 NR_UE_pow_sav_enh, to indicate that to support low-power decoding, the parameters such as the maximum code length, the minimum code rate, and the minimum segment quantity are limited. A bold part in FIG. 6C is new content.

Table 1

| Improvements compared with existing protocols | | | |
|---|---|---|---|
| Specification (specification) | Version (version) | Chapter (chapter) | New content (new content) |
| 38.306 | 17.4.0 | 4.2.7.10 phy-parameters | A field is added to indicate a decoding capability of a UE. |
| 38.331 | 17.4.0 | 6.3.3 UE capability information elements | IEs are added to indicate a maximum code length, a minimum code rate, and a maximum segment quantity that can be supported by a UE for decoding. |
| 38.822 | 17.0.0 | 5.1.4 NR_IIOT 5.1.11 UE Power Saving | A feature (feature) of a decoding capability of a UE is added. |
| | | 6.1.3 NR_IIOT_URLL-C_enh 6.1.7 NR_UE_pow_sa-v_enh | Components are added to NR_UE_pow_sav_enh to indicate that to support low-power decoding, parameters such as a maximum code length $N_{max}$, a minimum code rate $R_{min}$, and a minimum segment quantity are limited. |

In the foregoing embodiments provided in this application, the method provided in embodiments of this application is separately described from a perspective of interaction between the devices. To implement the functions in the methods provided in embodiments of this application, the first communication apparatus and the second communication apparatus each may include a hardware structure and/or a software module, to implement the foregoing functions in a form of a hardware structure, a software module, or a combination of a hardware structure and a software module. Whether a function in the foregoing functions is performed by using the hardware structure, the software module, or the combination of the hardware structure and the software module depends on particular applications and design constraints of the technical solutions.

In embodiments of this application, module division is an example, and is merely a logical function division. In actual implementation, another division manner may be used. In addition, functional modules in embodiments of this application may be integrated into one processor, or may exist alone physically, or two or more modules may be integrated into one module. The integrated module may be implemented in a form of hardware, or may be implemented in a form of a software functional module.

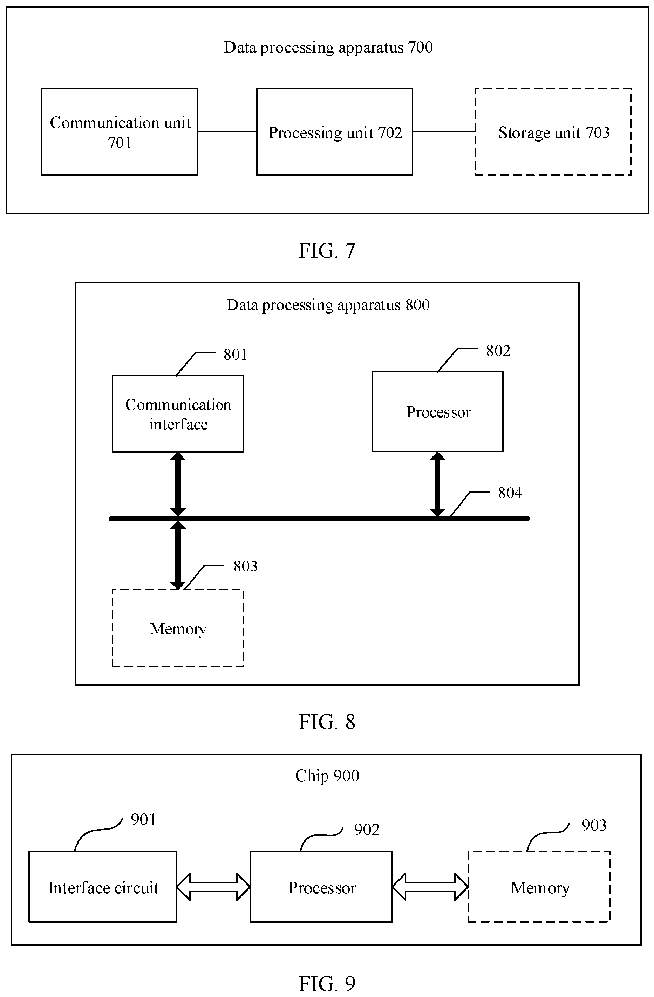

Same as the foregoing concept, as shown in FIG. 7, an embodiment of this application further provides a data processing apparatus 700, configured to implement functions of the first communication apparatus or the second communication apparatus in the foregoing method. For example, the data processing apparatus 700 may be a software module or a chip system. In embodiments of this application, the chip system may include a chip, or may include a chip and another discrete component. The data processing apparatus 700 may include a communication unit 701 and a processing unit 702.

In this embodiment of this application, the communication unit 701 may also be referred to as a transceiver unit, and may include a sending unit and/or a receiving unit, which are respectively configured to perform sending and receiving steps performed by the first communication apparatus or the second communication apparatus in the foregoing method embodiments. The processing unit 702 may be configured to read instructions and/or data in a storage module, to enable the data processing apparatus 700 to implement the foregoing method embodiments.

Optionally, the data processing apparatus 700 may further include a storage unit 703. The storage unit 703 is equivalent to a storage module, and may be configured to store instructions and/or data.

The following describes in detail communication apparatuses provided in embodiments of this application with reference to FIG. 7 and FIG. 8. It should be understood that descriptions of apparatus embodiments correspond to the descriptions of the method embodiments. Therefore, for content that is not described in detail, refer to the method embodiment in FIG. 3. For brevity, details are not described herein again.

The communication unit 701 may also be referred to as a transceiver, a transceiver machine, a transceiver apparatus, or the like. The processing unit may also be referred to as a processor, a processing board, a processing module, a processing apparatus, or the like. Optionally, a component that is in the communication unit 701 and that is configured to implement the receiving function may be considered as a receiving unit, and a component that is in the communication unit 701 and that is configured to implement the sending function may be considered as a sending unit. That is, the communication unit 701 includes the receiving unit and the sending unit. The communication unit sometimes may also be referred to as a transceiver machine, a transceiver, a transceiver circuit, or the like. The receiving unit sometimes may also be referred to as a receiver machine, a receiver, a receive circuit, or the like. The sending unit sometimes may also be referred to as a transmitter machine, a transmitter, a transmit circuit, or the like.

When the data processing apparatus 700 performs the first communication apparatus in the procedure shown in FIG. 3 in the foregoing embodiment,
the communication unit 701 obtains decoding capability information of the second communication apparatus.

The processing unit 702 is configured to: perform segmentation processing on a first information bit based on the decoding capability information of the second communication apparatus, to obtain information bits through segmentation; and perform encoding processing on the information bits obtained through segmentation, to obtain codeword bits.

The communication unit 701 is further configured to output the codeword bits.

When the data processing apparatus 700 performs the second communication apparatus in the procedure shown in FIG. 3 in the foregoing embodiment,
the communication unit 701 is configured to obtain codeword bits, where the codeword bits are obtained by performing encoding processing on information bits obtained through segmentation, and the information bits obtained through segmentation are obtained by performing segmentation processing on a first information bit based on decoding capability information of the second communication apparatus.

The processing unit 702 is configured to perform decoding processing on the codeword bits, to obtain the first information bit.

The foregoing is merely an example. The processing unit 702 and the communication unit 701 may further perform other functions. For more detailed descriptions, refer to related descriptions of the method embodiment shown in FIG. 3. Details are not described herein again.

FIG. 8 is a data processing apparatus 800 according to an embodiment of this application. The communication apparatus shown in FIG. 8 may be an implementation of a hardware circuit of the communication apparatus shown in FIG. 7. The data processing apparatus 800 may be applied to the flowchart shown above, and perform functions of the first communication apparatus or the second communication apparatus in the foregoing method embodiment. For ease of description, FIG. 8 shows only main components of the communication apparatus.

As shown in FIG. 8, the data processing apparatus 800 includes a communication interface 801 and a processor 802. The communication interface 801 and the processor 802 are coupled to each other. It may be understood that the communication interface 801 may be a transceiver or an input/output interface, or may be an interface circuit like a transceiver circuit. Optionally, the data processing apparatus 800 may further include a memory 803, configured to: store instructions executed by the processor 802, or store input data required for running instructions by the processor 802, or store data generated after the processor 802 runs instructions.

When the data processing apparatus 800 is configured to implement the method shown in FIG. 3, the processor 802 is configured to implement a function of the processing unit 702, and the communication interface 801 is configured to implement a function of the communication unit 701.

A specific connection medium between the communication interface 801, the processor 802, and the memory 803 are not limited in embodiments of this application. In this embodiment of this application, in FIG. 8, the memory 803, the processor 802, and the communication interface 801 are connected to each other through a communication bus 804. The communication bus 804 is represented by using a thick line in FIG. 8. A manner of connection between other components is only schematically described, but is not used as a limitation. The communication bus 804 may be classified into an address bus, a data bus, a control bus, and the like. For ease of representation, only one thick line is used for representing the bus in FIG. 8, but this does not mean that there is only one bus or only one type of bus.

When the communication apparatus is a chip, FIG. 9 is a diagram of a simplified apparatus structure of the chip. The chip 900 includes an interface circuit 901 and one or more processors 902. Optionally, the chip 900 may further include a bus. Specifically:

The processor 902 may be an integrated circuit chip, and has a signal processing capability. In an implementation process, the steps in the foregoing data processing method can be completed by using an integrated logic circuit of hardware in the processor 902, or by using instructions in a form of software. The processor 902 may be a general-purpose processor, a digital signal processor (DSP), an application-specific integrated circuit (ASIC), a field programmable gate array (FPGA) or another programmable logic device, a discrete gate or a transistor logic device, or a discrete hardware component. The processor 902 may implement or perform the methods and steps that are disclosed in embodiments of this application. The general-purpose processor may be a microprocessor, or the processor may be any conventional processor or the like.

The interface circuit 901 may be configured to send or receive data, instructions, or information. The processor 902 may perform processing by using the data, the instructions, or other information received by the interface circuit 901, and may send processed information through the interface circuit 901.

Optionally, the chip further includes a memory 903. The memory 903 may include a read-only memory and a random access memory, and provide operation instructions and data for the processor. A part of the memory 903 may further include a non-volatile random access memory (NVRAM).

Optionally, the memory stores an executable software module or a data structure, and the processor may perform a corresponding operation by invoking the operation instructions stored in the memory (the operation instructions may be stored in an operating system).

Optionally, the chip may be used in the first communication apparatus or the second communication apparatus in embodiments of this application. Optionally, the interface circuit 901 may be configured to output an execution result of the processor 902. For the data processing method provided in one or more embodiments of this application, refer to the foregoing embodiments. Details are not described herein again.

It should be noted that functions corresponding to each of the interface circuit 901 and the processor 902 may be implemented by using a hardware design, may be implemented by using a software design, or may be implemented by using a combination of software and hardware. This is not limited herein.

An embodiment of this application further provides a computer-readable storage medium. The computer-readable storage medium stores computer instructions used to implement the method performed by the first communication apparatus or the second communication apparatus in the foregoing method embodiment.

For example, when a computer program is executed by a computer, the computer is enabled to implement the method performed by the first communication apparatus or the second communication apparatus in the foregoing method embodiment.

An embodiment of this application further provides a computer program product including instructions. When the instructions are executed by a computer, the computer is enabled to implement the method performed by the first communication apparatus or the second communication apparatus in the foregoing method embodiment.

An embodiment of this application further provides a chip including a processor. The processor is configured to invoke a computer program or computer instructions stored in a memory, so that the processor performs the data processing method in the embodiment shown in FIG. 3.

In a possible implementation, an input of the chip corresponds to the receiving operation in the embodiment shown in FIG. 3, and an output of the chip corresponds to the sending operation in the embodiment shown in FIG. 3.

Optionally, the processor is coupled to the memory through an interface.

Optionally, the chip further includes the memory. The memory stores the computer program or the computer instructions.

The processor described above at any location may be a general central processing unit, a microprocessor, an application-specific integrated circuit (application-specific integrated circuit, ASIC), or one or more integrated circuits configured to control program execution of the data processing method in embodiments shown in FIG. 3, FIG. 4A, and FIG. 7. The memory described above at any location may be a read-only memory (read-only memory, ROM), another type of static storage device that can store static information and instructions, a random access memory (random access memory, RAM), or the like.

It should be noted that for ease and brevity of description, for explanations and beneficial effect of related content of any one of the communication apparatuses provided above, refer to the corresponding data processing method embodiments provided above. Details are not described herein again.

In this application, a hardware layer, an operating system layer running above the hardware layer, and an application layer running above the operating system layer may be further included between communication apparatuses. The hardware layer may include hardware such as a central processing unit (central processing unit, CPU), a memory management unit (memory management unit, MMU), and a memory (also referred to as a main memory). An operating system at the operating system layer may be any one or more computer operating systems that implement service processing by using a process (process), for example, a Linux operating system, a Unix operating system, an Android operating system, an iOS operating system, or a Windows operating system. The application layer may include applications such as a browser, an address book, word processing software, and instant messaging software.

Division into the modules in embodiments of this application is an example, is merely division into logical functions, and may be other division during actual implementation. In addition, functional modules in embodiments of this application may be integrated into one processor, or each of the modules may exist alone physically, or two or more modules may be integrated into one module. The integrated module may be implemented in a form of hardware, or may be implemented in a form of a software functional module.

Through descriptions of the foregoing implementations, a person skilled in the art may clearly understand that embodiments of this application may be implemented by hardware, firmware or a combination thereof. When embodiments are implemented by software, the foregoing functions may be stored in a computer-readable medium or transmitted as one or more instructions or code in the computer-readable medium. The computer-readable medium includes a computer storage medium and a communication medium, where the communication medium includes any medium that enables a computer program to be transmitted from one place to another. The storage medium may be any available medium accessible to a computer. Examples of the computer-readable medium include but are not limited to: a RAM, a ROM, an electrically erasable programmable read-only memory (electrically erasable programmable read-only memory, EEPROM), a compact disc read-only memory (compact disc read-only memory, CD-ROM) or another optical disc storage, a disk storage medium or another disk storage device, or any other medium that can be used to carry or store expected program code in an instruction or data structure form and can be accessed by a computer. In addition, any connection may be properly defined as a computer-readable medium. For example, if software is transmitted from a website, a server, or another remote source via a coaxial cable, an optical fiber and optical cable, a twisted pair, a digital subscriber line (digital subscriber line, DSL), or wireless technologies such as infrared, radio, and microwave, the coaxial cable, the optical fiber and optical cable, the twisted pair, the DSL, or the wireless technologies such as infrared, radio, and microwave are included in a definition of a medium to which the coaxial cable, the optical fiber and optical cable, the twisted pair, the DSL, or the wireless technologies such as the infrared ray, the radio, and the microwave belong. For example, a disk (disk) and a disc (disc) used in embodiments of this application include a compact disc (compact disc, CD), a laser disc, an optical disc, a digital video disc (digital video disc, DVD), a floppy disk and a Blu-ray disc. The disk generally copies data by a magnetic means, and the disc copies data optically by a laser means. The foregoing combination should also be included in the protection scope of the computer-readable medium.

**Claims**

1. A data processing method, wherein the method is applied to a first communication apparatus and comprises:

   obtaining decoding capability information of a second communication apparatus;
   performing segmentation processing on a first information bit based on the decoding capability information of the second communication apparatus, to obtain information bits through segmentation;
   performing encoding processing on the information bits obtained through segmentation, to obtain codeword bits;

and
outputting the codeword bits.

2. The method according to claim 1, wherein obtaining the decoding capability information of the second communication apparatus comprises:

obtaining first information, wherein the first information indicates the decoding capability information of the second communication apparatus; or
obtaining capability information of the second communication apparatus, wherein a first field in the capability information of the second communication apparatus indicates the decoding capability information of the second communication apparatus; or
obtaining type information of the second communication apparatus, wherein the type information of the second communication apparatus comprises the decoding capability information of the second communication apparatus.

3. The method according to claim 2, wherein the decoding capability information of the second communication apparatus is a maximum length $N_{max}$ that is of a codeword and that is supported by the second communication apparatus for decoding.

4. The method according to claim 2, wherein the decoding capability information of the second communication apparatus is a minimum code rate $R_{min}$ that is of a codeword and that is supported by the second communication apparatus for decoding, $R_{min} = A/N_{max}$, A is a quantity of bits of the first information bit, and $N_{max}$ is a maximum length that is of the codeword and that is supported by the second communication apparatus for decoding.

5. The method according to claim 3, wherein performing segmentation processing on the first information bit based on the decoding capability information of the second communication apparatus, to obtain the information bits through segmentation comprises:
performing segmentation processing based on a code rate, the first information bit, and the maximum length $N_{max}$ that is of the codeword and that is supported by the second communication apparatus for decoding.

6. The method according to claim 5, wherein performing segmentation processing based on the code rate, the first information bit, and the maximum length $N_{max}$ that is of the codeword and that is supported by the second communication apparatus for decoding comprises:

determining an initial segmentation value C' based on a quantity L of bits of cyclic redundancy check CRC concatenated to each segment, the code rate, $N_{max}$, and a quantity of bits of the first information bit, wherein L is a preset integer greater than or equal to 0, and C' is an integer greater than or equal to 1;
corresponding to the code rate being greater than or equal to a preset code rate, determining that a segment quantity is equal to C'; and
corresponding to the code rate being less than the preset code rate, determining that the segment quantity is equal to C1, wherein C1 is a positive integer less than or equal to C'.

7. The method according to claim 6, wherein performing encoding processing on the information bits obtained through segmentation, to obtain the codeword bits comprises:

concatenating a segment of the CRC with the quantity L of bits at a tail of each segment of information bits obtained through segmentation, to obtain each segment of concatenated information bits; and
encoding each segment of concatenated information bits, to obtain each segment of codeword bits.

8. The method according to claim 7, wherein when a quantity of transmission resource units occupied by C1 segments of codeword bits is less than a total quantity of transmission resource units, the method further comprises:
retransmitting a part of codeword bits or all of codeword bits in the C1 segments of codeword bits via a remaining transmission resource unit in the total transmission resource units.

9. The method according to claim 6, wherein the initial segmentation value C' satisfies the following formula:

$$C' = \left\lceil \frac{A}{K_{cb} - L} \right\rceil,$$

wherein

$K_{cb}$ is a maximum value of a quantity of information bits of each segment obtained through segmentation,

$K_{cb} = \lceil R \times N_{max} \rceil$, $R$ is the code rate, A is the quantity of bits of the first information bit, and $\lceil \ \rceil$ is a ceiling symbol.

**10.** The method according to claim 6, wherein $C1 = \lceil C'/y \rceil$, and y is an integer greater than or equal to 1.

**11.** The method according to claim 3, wherein performing segmentation processing on the first information bit based on the decoding capability information of the second communication apparatus, to obtain the information bits through segmentation comprises:
performing segmentation processing based on a total quantity of transmission resource units, a modulation order, the first information bit, and the maximum length $N_{max}$ that is of the codeword and that is supported by the second communication apparatus for decoding, wherein $N_{max}$ is a value greater than 0.

**12.** The method according to claim 11, wherein performing segmentation processing based on the total quantity of transmission resource units, the modulation order, the first information bit, and the maximum length $N_{max}$ that is of the codeword and that is supported by the second communication apparatus for decoding comprises:

determining an initial segmentation value $C_3$ based on the total quantity of transmission resource units, the modulation order, and the maximum length $N_{max}$ that is of the codeword and that is supported by the second communication apparatus for decoding, wherein $C_3$ is a positive integer;
calculating a quantity of bits of a remaining transmission resource based on the total quantity of transmission resource units, the modulation order, the initial segmentation value $C_3$, and the maximum length $N_{max}$ that is of the codeword and that is supported by the second communication apparatus for decoding;
if the quantity of bits of the remaining transmission resource is less than a preset value, determining that the segment quantity is equal to $C_3$; and
if the quantity of bits of the remaining transmission resource is not less than the preset value, determining that the segment quantity is equal to $C_3 + 1$.

**13.** The method according to claim 12, wherein the initial segmentation value $C_3$ satisfies the following formula:

$$C_3 = \lfloor Q_m \times E_{total}/N_{max} \rfloor,$$

wherein

the quantity of bits of the remaining transmission resource satisfies the following formula:

$$B_{rest} = E_{total} \times Q_m - C_3 \times N_{max},$$

and
the segment quantity C satisfies the following formula:
when

$$B_{rest} < z \cdot N_{max}, C = C_3;$$

or
when

$$B_{rest} \geq z \cdot N_{max}, C = C_3 + 1,$$

wherein

$Q_m$ is the modulation order, $E_{total}$ is the total quantity of transmission resource units, $B_{rest}$ is the quantity of bits of the remaining transmission resource, $z \cdot N_{max}$ is the preset value, $z$ is a value greater than 0 and less than 1, and $\lfloor \rfloor$ is a floor symbol.

14. The method according to claim 12, wherein when a quantity of transmission resource units occupied by $C_3$ segments of codeword bits is less than the total quantity of transmission resource units, the method further comprises:
    retransmitting a part of codeword bits or all of codeword bits in the $C_3$ segments of codeword bits via a remaining transmission resource unit in the total transmission resource units.

15. The method according to claim 12, wherein when a quantity of transmission resource units occupied by first $C_3$ segments of codeword bits in $C_3 + 1$ segments of codeword bits is less than the total quantity of transmission resource units, the method further comprises:
    transmitting a last segment of codeword bits via a remaining transmission resource unit in the total transmission resource units.

16. A data processing method, wherein the method is applied to a second communication apparatus and comprises:

    obtaining codeword bits, wherein the codeword bits are obtained by performing encoding processing on information bits obtained through segmentation, and the information bits obtained through segmentation are obtained by a first communication apparatus by performing segmentation processing on a first information bit based on decoding capability information of the second communication apparatus; and
    performing decoding processing on the codeword bits, to obtain the first information bit.

17. The method according to claim 16, wherein the method further comprises:

    outputting first information, wherein the first information indicates the decoding capability information of the second communication apparatus; or
    outputting capability information of the second communication apparatus, wherein a first field in the capability information of the second communication apparatus indicates the decoding capability information of the second communication apparatus; or
    outputting type information of the second communication apparatus, wherein the type information of the second communication apparatus comprises the decoding capability information of the second communication apparatus.

18. The method according to claim 17, wherein the decoding capability information of the second communication apparatus is a maximum length $N_{max}$ that is of a codeword and that is supported by the second communication apparatus for decoding.

19. The method according to claim 17, wherein the decoding capability information of the second communication apparatus is a minimum code rate $R_{min}$ that is of a codeword and that is supported by the second communication apparatus for decoding, $R_{min} = A/N_{max}$, A is a quantity of bits of the first information bit, and $N_{max}$ is a maximum length that is of the codeword and that is supported by the second communication apparatus for decoding.

20. The method according to any one of claims 16 to 19, wherein when C' segments of codeword bits are received from the first communication apparatus, C' is an integer greater than or equal to 1; and
    performing decoding processing on the codeword bits, to obtain the first information bit comprises:

    performing decoding processing on the C' segments of codeword bits, to obtain C' segments of concatenated information bits; and
    removing CRC code from the C' segments of concatenated information bits, to obtain the first information bit.

21. The method according to any one of claims 16 to 19, wherein when $C_1$ segments of codeword bits and codeword bits that are a part of the $C_1$ segments of codeword bits and that are retransmitted are received from the first communication apparatus, C1 is a positive integer less than or equal to C'; and
    performing decoding processing on the codeword bits, to obtain the first information bit comprises:

    combining soft bits corresponding to the C1 segments of codeword bits and soft bits corresponding to the retransmitted codeword bits and performing decoding, to obtain concatenated information bits; and

removing CRC code from the concatenated information bits, to obtain the first information bit.

22. The method according to either of claims 16 and 17, wherein when $C_3$ segments of codeword bits and codeword bits that are a part of the $C_3$ segments of codeword bits and that are retransmitted are received from the first communication apparatus, $C_3$ is a positive integer; and
performing decoding processing on the codeword bits, to obtain the first information bit comprises:

combining soft bits corresponding to the $C_3$ segments of codeword bits and soft bits corresponding to the retransmitted codeword bits, and performing decoding, to obtain concatenated information bits; and
removing CRC code from the concatenated information bits, to obtain the first information bit.

23. The method according to either of claims 16 and 17, wherein when $C_3 + 1$ segments of codeword bits are received from the first communication apparatus, $C_3$ is a positive integer; and
performing decoding processing on the codeword bits, to obtain the first information bit comprises: performing decoding processing on the $C_3 + 1$ segments of codeword bits, to obtain $C_3 + 1$ segments of concatenated information bits; and removing CRC code from the $C_3 + 1$ segments of concatenated information bits, to obtain the first information bit.

24. A data processing apparatus, comprising a module or a unit configured to perform the method according to any one of claims 1 to 15 or a module or a unit configured to perform the method according to any one of claims 16 to 23.

25. A data processing apparatus, comprising a processor and an interface circuit, wherein the interface circuit is configured to receive a signal from an apparatus other than the apparatus and transmit the signal to the processor, or send a signal from the processor to a communication apparatus other than the apparatus, and the processor implements the method according to any one of claims 1 to 15 or implements the method according to any one of claims 16 to 23 through a logic circuit or by executing code instructions.

26. A computer-readable storage medium, wherein the storage medium stores a computer program or instructions, and when the computer program or the instructions are executed by a communication apparatus, the method according to any one of claims 1 to 23 is implemented.

27. A computer program product, wherein the computer program product stores computer-readable instructions, and when the computer-readable instructions are run, the method according to any one of claims 1 to 23 is performed.

FIG. 1

Source → Source encoding → **Channel encoding** → Modulation → Channel → Demodulation → **Channel decoding** → Source decoding → Destination

FIG. 2

```
┌──────────────────────┐                    ┌──────────────────────┐
│   First communication │                    │  Second communication │
│       apparatus       │                    │       apparatus       │
└──────────────────────┘                    └──────────────────────┘
            │                                            │
┌──────────────────────┐                                 │
│ S301: Obtain decoding │                                 │
│  capability           │                                 │
│  information of the   │                                 │
│  second               │                                 │
│  communication        │                                 │
│  apparatus            │                                 │
└──────────────────────┘                                 │
            │                                            │
┌──────────────────────┐                                 │
│ S302: Perform         │                                 │
│ segmentation          │                                 │
│ processing on a first │                                 │
│ information bit based │                                 │
│ on the decoding       │                                 │
│ capability            │                                 │
│ information of the    │                                 │
│ second communication  │                                 │
│ apparatus, to obtain  │                                 │
│ information bits      │                                 │
│ through segmentation  │                                 │
└──────────────────────┘                                 │
            │                                            │
┌──────────────────────┐                                 │
│ S303: Perform         │                                 │
│ encoding processing   │                                 │
│ on the information    │                                 │
│ bits through          │                                 │
│ segmentation, to      │                                 │
│ obtain codeword bits  │                                 │
└──────────────────────┘                                 │
            │                                            │
            │   S304: Output the codeword bits           │
            │───────────────────────────────────────────▶│
            │                                            │
            │                              ┌──────────────────────┐
            │                              │ S305: Perform         │
            │                              │ decoding processing   │
            │                              │ on the codeword bits, │
            │                              │ to obtain the first   │
            │                              │ information bit       │
            │                              └──────────────────────┘
            ▼                                            ▼
```

FIG. 3

**Step 1:** Determine a maximum value $K_{cb}$ of a quantity of message bits of each segment based on a maximum code length $N_{max}$ supported by a UE 1 and a current code rate $R$; and

set a maximum mother code length that can be supported by the UE 1 for decoding to $N_{max}$, where $K_{cb} = [R \times N_{max}]$, and $R$ is the current code rate

**Step 2:** Determine a segment quantity based on $K_{cb}$:

if A $\quad K_{cb}$,

   L = 0; a quantity of code blocks: C = 1; and A' = A

else

    L = 11; a quantity of code blocks: C = $[A/(K_{cb} - L)]$; and A' = C * $K_{cb}$

end if

**Step 3:** Evenly divide A' input bits into **C** segments, and concatenate **L**-bit **CRC** to each segment:

Bits output through code block segmentation are represented as:

$C_{r0}$, $C_{r1}$, $C_{r2}$,   , $C_{r(Kr-1)}$, where $r$ indicates a code block number, and $K_r$ is a quantity of bits of the code block with the number $r$.

A quantity $K$ of bits of each code block is calculated as: K' = A'/C;

A bit sequence $C_{rk}$ is calculated as follows:

$s = 0$;

for $r = 0$ to C − 1;

   for $k = 0$ to K' − $L$ − 1;

      $C_{rk} = a_s'$;

       $s = s + 1$;

   end for

$C_{r0}$, $C_{r1}$, $C_{r2}$,   , $C_{r(Kr-1)}$ is used to calculate check bits $p_{r0}$, $p_{r1}$, $p_{r2}$,   , $p_{r(Kr-1)}$ of CRC

for $k$ = K' − L to K' − 1

   $C_{rk} = p_{r(k+L-k')}$;

end for

FIG. 4A

Payload size: A

Resource size: B

Step 1: Calculate $K_{cb} = \lceil R \times N_{max} \rceil$ based on $N_{max}$ and a current code rate R

Step 2: Determine a segment quantity $C = \lceil A/K_{cb} \rceil$ based on $K_{cb}$, where $A' = C * K_{cb}$

Step 3: Evenly divide $A'$ bits into C segments

A

CB 0 = A'/C
CB 1 = A'/C
CB 2 = A'/C
CB 3 = A'/C
CB 4 = A'/C
CB 5 = A'/C
CB 6 = A'/C
CB 7 = A'/C

Division into eight segments

Encoding

Code rate of each segment being 1/8

B0 = B/C
B1 = B/C
B4 = B/C
B5 = B/C
B6 = B/C
B7 = B/C

FIG. 4B

Payload size | A = 128 bits (bits)

Resource size | B = 128 * 8 bits (bits)

A = 128 bits

Step 1: Calculate $K_{cb}$ = 16 based on $N_{max}$ and a current code rate R

Step 2: Determine a segment quantity $C$ = ⌈128/16⌉ = 8 based on $K_{cb}$

Step 3: Evenly divide 128 bits into 8 segments

| CB 1 = 16 bits | CB 2 = 16 bits | CB 3 = 16 bits | CB 4 = 16 bits | CB 5 = 16 bits | CB 6 = 16 bits | CB 7 = 16 bits | CB 8 = 16 bits |

Division into eight segments

Encoding

| B0 = 128 bits | B1 = 128 bits | ... | B4 = 128 bits | B5 = 128 bits | B6 = 128 bits | B7 = 128 bits |

Code rate of each segment being 1/8

FIG. 4C

EP 4 779 907 A1

Payload
size

| A |

Resource
size

| B |

| A |

CB 0 =
2A'/C

CB 1 =
2A'/C

CB 2 =
2A'/C

CB 3 =
2A'/C

B0 = B/C

B1 = B/C

B2 = B/C

B3 = B/C

B4 = B0

B5 = B1

B6 = B2

B7 = B3

Copy

Step 1: Based on Embodiment 1, determine an initial segment quantity C. In this case, an actual segment quantity is C/2

Step 2: Divide A into C/2 segments, and encode each segment into short code with a code rate of 2R and a code length of B/C

Step 3: Repeatedly send previously encoded codewords via remaining half of resources

Division into
C/2 segments

Encoding

Code rate of
each segment
being (2A)/B

EP 4 779 907 A1

FIG. 5A

Payload size | A = 128 bits (bits)

Resource size | B = 128 * 8 bits (bits)

A = 128 bits

CB 0 = 32 bits | CB 1 = 32 bits | CB 2 = 32 bits | CB 3 = 32 bits

B0 = 128 bits | B1 = 128 bits | B2 = 128 bits | B3 = 128 bits

B0 | B1 | B2 | B3

Copy

Step 1: For a current code rate 1/8 less than 3/8, determine that an initial segment quantity is 8

Step 2: For a segment quantity C = 8/2 = 4, divide A into 4 segments, where a code rate of each encoded segment is 1/4 and a code length is 128 bits

Step 3: Repeatedly send previously encoded codewords via remaining half of resources

Division into four segments

Encoding

Code rate of each segment being 1/4

FIG. 5B

Polarization (polarization) (K = 256 N = 512) Orthogonal phase shift keying OPSK
modulation/Additive white Gaussian noise AWGN

FIG. 5C

EP 4 779 907 A1

| Definitions for parameters (Definitions for parameters) | Per (Per) | M (M) | FDD-TDD DIFF (FDD-TDD DIFF) | FR1-FR2 DIFF (FR1-FR2 DIFF) |
|---|---|---|---|---|
| *uci*-CodeBlockSegmentation<br><br>Indicates whether the UE supports segmenting UCI into multiple code blocks depending on the payload size.<br><br>(Indicates whether the UE supports segmenting UCI into multiple code blocks depending on the payload size) | UE | Yes | No | Yes |
| ue-PowerClass<br>ue-PowerClass-v1610<br>ue-PowerClass-v1700<br><br>For FR1, if the UE supports the different UE power class than the default UE power class as defined in clause 6.2 of TS 38.101-1 [2], the UE shall report the supported UE power class in this field.<br>For FR2, UE shall report the supported UE power class as defined in clause 6 and 7 of TS 38.101-2 [3] in this field. UE indicating support for *pc6* supports the enhanced intra-NR RRM and demodulation processing requirements for FR2 to support high speed up to 350 km/h as specified in TS 38.133 [5]. This capability is not applicable to IAB-MT. The power class pc7 is only applicable for RedCap UEs operation in FR2. (For FR1, if the UE supports the different UE power class than the default UE power class as defined in clause 6.2 of TS 38.101-1 [2], the UE shall report the supported UE power class in this field. For FR2, UE shall report the supported UE power | Band (Band) | Yes | No (N/A) | No (N/A) |

| Definitions for parameters (Definitions for parameters) | Per (Per) | M (M) | FDD-TDD DIFF (FDD-TDD DIFF) | FR1-FR2 DIFF (FR1-FR2 DIFF) |
|---|---|---|---|---|
| class as defined in clause 6 and 7 of TS 38.101-2 [3] in this field. UE indicating support for *pc6* supports the enhanced intra-NR RRM and demodulation processing requirements for FR2 to support high speed up to 350 km/h as specified in TS 38.133 [5]. This capability is not applicable to IAB-MT. The power class pc7 is only applicable for RedCap UEs operation in FR2) | | | | |
| **maxModulationOrderForMulticast-r17** Defines the maximal modulation order for multicast PDSCH. If not reported, UE supports the same modulation order as unicast. For FR1, up to 1024QAM is supported. For FR2, up to 256QAM is supported. A UE supporting this feature shall also indicate support of dynamicMulticastPCell-r17. NOTE: A UE shall support the corresponding mandatory maximum modulation for unicast. **(maxModulationOrderF orMulticast-r17** Defines the maximal modulation order for multicast PDSCH. If not reported, UE supports the same modulation order as unicast.-For FR1, up to 1024QAM is supported.-For FR2, up to 256QAM is supported. A UE supporting this feature shall also indicate support of dynamicMulticastPCell-r17. NOTE: A UE shall support the corresponding mandatory maximum modulation for unicast) | Band (Band) | No | No (N/A) | No (N/A) |

| Definitions for parameters (Definitions for parameters) | Per (Per) | M (M) | FDD-TDD DIFF (FDD-TDD DIFF) | FR1-FR2 DIFF (FR1-FR2 DIFF) |
|---|---|---|---|---|
| UE decoding capability<br><br>Defines the UE decoding capability, including maximum code length $N_{max}$, minimum code rate $R_{min}$, lifting size set, etc. (defines the UE decoding capability, including maximum code length $N_{max}$, minimum code rate $R_{min}$, lifting size set, etc) | UE | Yes | No | Yes |

FIG. 6A

```
Physical layer parameters Phy-ParametersFRX-Diff::= SEQUENCE {
    csi-ReportWithoutPMI              ENUMERATED {supported}        OPTIONAL,
    csi-ReportWithoutCQI              ENUMERATED {supported}        OPTIONAL,
    onePortsPTRS                      BIT STRING (SIZE (2))         OPTIONAL,
    twoPUCCH-F0-2-ConsecSymbols       ENUMERATED {supported}        OPTIONAL,
    pucch-F2-WithFH                   ENUMERATED {supported}        OPTIONAL,
    pucch-F3-WithFH                   ENUMERATED {supported}        OPTIONAL,
    pucch-F4-WithFH                   ENUMERATED {supported}        OPTIONAL,
    freqHoppingPUCCH-F0-2             ENUMERATED {notSupported}     OPTIONAL,
    freqHoppingPUCCH-F1-3-4           ENUMERATED {notSupported}     OPTIONAL,
    mux-SR-HARQ-ACK-CSI-PUCCH         ENUMERATED {supported}        OPTIONAL,
    uci-CodeBlockSegmentation         ENUMERATED {supported}        OPTIONAL,
    onePUCCH-LongAndShortFormat       ENUMERATED {supported}        OPTIONAL,
    twoPUCCH-AnyOthersInSlot          ENUMERATED {supported}        OPTIONAL,
    intraSlotFreqHopping-PUSCH        ENUMERATED {supported}        OPTIONAL,
    pusch-LBRM                        ENUMERATED {supported}        OPTIONAL,
    pdcch-BlindDetectionCA            ENUMERATED {supported}        OPTIONAL,
    tpc-PUSCH-RNTI                    ENUMERATED {supported}        OPTIONAL,
    tpc-PUCCH-RNTI                    ENUMERATED {supported}        OPTIONAL,
    tpc-SRS-RNTI                      ENUMERATED {supported}        OPTIONAL,
    pusch-HalfPi-BPSK                 ENUMERATED {supported}        OPTIONAL,
    pucch-F3-4-HalfPi-BPSK            ENUMERATED {supported}        OPTIONAL,
    UE-defined-maxCodeLength          ENUMERATED {supported}        OPTIONAL,
    UE-defined-minCodeRate            ENUMERATED {supported}        OPTIONAL,
    UE-defined-codeBlockNum           ENUMERATED {supported}        OPTIONAL,
    UE-defined-liftingSizeSet         ENUMERATED {supported}        OPTIONAL,
    ...
}
```

FIG. 6B

EP 4 779 907 A1

| Features (Features) | Index (Index) | Feature group (Feature group) | Components (Components) | Prerequisite feature groups (Prerequisite feature groups) | Field names in TS 38.331 [2] | Parent (IE) in TS 38.331 [2] | Need to distinguish FDD/TDD |
|---|---|---|---|---|---|---|---|
| 29. NR_UE_ pow_sav_ enh | 29-3a | PDCCH skipping (PDCCH skipping) | Support of up to 2-bit indication of PDCCH skipping by scheduling DCI if SSSG is not configured (Support of up to 2-bit indication of PDCCH skipping by scheduling DCI if SSSG is not configured) | | pdcch-SkippngWithou tSSSG-r17 (pdcch-SkippngWithou tSSSG-r17) | BandNR (BandNR) | No (N/A) |
| 29. NR_UE_ pow_sav _enh | 29-3w | Low-power decoding | Supported code length $N_{max}$ = xxx code length | | Defined maximum code length (UE-defined-maxCodeLeng th) | Physical paramete r (Phy-Paramet ersFRX-Diff) | Y |

| Features (Features) | Index (Index) | Feature group (Feature group) | Components (Components) | Prerequisite feature groups (Prerequisite feature groups) | Field names in TS 38.331 [2] | Parent (IE) in TS 38.331 [2] | Need to distinguish FDD/TDD |
|---|---|---|---|---|---|---|---|
| 29. NR_UE_ pow_sav _enh | 29-3x | Low-power decoding | **Supported minimum code rate xxx** | | **Defined minimum code rate (UE-defined-minCodeRate)** | **Physical paramete r (Phy-Paramet ersFRX-Diff )** | Y |
| 29. NR_UE_ pow_sav _enh | 29-3y | Low-power decoding | **Supported maximum quantity xxx of code blocks** | | **Defined quantity of code blocks (UE-defined-codeBlockNu m)** | **Physical paramete r (Phy-Paramet ersFRX-Diff )** | Y |
| 29. NR_UE_ pow_sav _enh | 29-3z | Low-power decoding | **Lifting size is selected from set {xxx} (Lifting size is selected from set {xxx})** | | **Defined lifting size set (UE-defined-liftingSizeSet)** | **Physical paramete r (Phy-Paramet ersFRX-Diff )** | Y |

FIG. 6C

Data processing apparatus 700

| Communication unit 701 | Processing unit 702 | Storage unit 703 |

FIG. 7

Data processing apparatus 800

801 Communication interface

802 Processor

804

803 Memory

FIG. 8

Chip 900

901 Interface circuit

902 Processor

903 Memory

FIG. 9

## INTERNATIONAL SEARCH REPORT

International application No.

**PCT/CN2023/120173**

| A. | CLASSIFICATION OF SUBJECT MATTER |
|---|---|

H04L1/00(2006.01)i

According to International Patent Classification (IPC) or to both national classification and IPC

| B. | FIELDS SEARCHED |
|---|---|

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT; CNABS; CNKI; VEN; WOTXT; USTXT; EPTXT; 3GPP: 编码, 译码, 能力, 性能, 分段, 极化码, 最大, 码长, 长度, 最低, 码率, 速率, 支持, encode, decode, performance, ability, segment, polar, maximum, length, minimum, rate, support

| C. | DOCUMENTS CONSIDERED TO BE RELEVANT | |
|---|---|---|

| Category* | Citation of document, with indication, where appropriate, of the relevant passages | Relevant to claim No. |
|---|---|---|
| X | CN 108574561 A (HUAWEI TECHNOLOGIES CO., LTD.) 25 September 2018 (2018-09-25) description, paragraphs [0046]-[0059] and [0103]-[0160], and figure 6 | 1-27 |
| X | CN 108631930 A (HUAWEI TECHNOLOGIES CO., LTD.) 09 October 2018 (2018-10-09) description, paragraphs [0033]-[0095] and [0114]-[0174] | 1-27 |
| A | CN 109842458 A (CHINA ACADEMY OF TELECOMMUNICATIONS TECHNOLOGY) 04 June 2019 (2019-06-04) entire document | 1-27 |
| A | CN 111357204 A (QUALCOMM INC.) 30 June 2020 (2020-06-30) entire document | 1-27 |
| A | US 2019158221 A1 (QUALCOMM INC.) 23 May 2019 (2019-05-23) entire document | 1-27 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **17 May 2024** | **22 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 779 907 A1**

| INTERNATIONAL SEARCH REPORT | | International application No. |
|---|---|---|
| Information on patent family members | | **PCT/CN2023/120173** |

| Patent document cited in search report | | | Publication date (day/month/year) | Patent family member(s) | | | Publication date (day/month/year) |
|---|---|---|---|---|---|---|---|
| CN | 108574561 | A | 25 September 2018 | EP | 3584972 | A1 | 25 December 2019 |
| | | | | EP | 3584972 | A4 | 26 February 2020 |
| | | | | WO | 2018166423 | A1 | 20 September 2018 |
| | | | | US | 2020007163 | A1 | 02 January 2020 |
| | | | | US | 11088709 | B2 | 10 August 2021 |
| CN | 108631930 | A | 09 October 2018 | EP | 3598673 | A1 | 22 January 2020 |
| | | | | EP | 3598673 | A4 | 08 April 2020 |
| | | | | EP | 3598673 | B1 | 25 August 2021 |
| | | | | WO | 2018171790 | A1 | 27 September 2018 |
| | | | | US | 2020322086 | A1 | 08 October 2020 |
| | | | | US | 11251903 | B2 | 15 February 2022 |
| | | | | US | 2020021392 | A1 | 16 January 2020 |
| | | | | US | 10637609 | B2 | 28 April 2020 |
| | | | | EP | 3934138 | A1 | 05 January 2022 |
| | | | | EP | 3934138 | B1 | 03 May 2023 |
| | | | | BR | 112019019532 | A2 | 22 April 2020 |
| | | | | BR | 112019019532 | B1 | 13 October 2021 |
| | | | | JP | 2020519045 | A | 25 June 2020 |
| | | | | JP | 6986091 | B2 | 22 December 2021 |
| CN | 109842458 | A | 04 June 2019 | WO | 2019100795 | A1 | 31 May 2019 |
| | | | | KR | 20200090877 | A | 29 July 2020 |
| | | | | KR | 102365382 | B1 | 18 February 2022 |
| | | | | US | 2020389249 | A1 | 10 December 2020 |
| | | | | US | 11476971 | B2 | 18 October 2022 |
| | | | | EP | 3716509 | A1 | 30 September 2020 |
| | | | | EP | 3716509 | A4 | 30 December 2020 |
| | | | | JP | 2021505028 | A | 15 February 2021 |
| | | | | JP | 7039699 | B2 | 22 March 2022 |
| CN | 111357204 | A | 30 June 2020 | KR | 20200086682 | A | 17 July 2020 |
| | | | | SG | 11202003268 | VA | 28 May 2020 |
| | | | | BR | 112020009643 | A2 | 10 November 2020 |
| | | | | WO | 2019095270 | A1 | 23 May 2019 |
| | | | | WO | 2019096168 | A1 | 23 May 2019 |
| | | | | JP | 2021503766 | A | 12 February 2021 |
| | | | | JP | 7285836 | B2 | 02 June 2023 |
| | | | | US | 2021288663 | A1 | 16 September 2021 |
| | | | | US | 11515889 | B2 | 29 November 2022 |
| | | | | EP | 3711167 | A1 | 23 September 2020 |
| | | | | EP | 3711167 | A4 | 18 August 2021 |
| US | 2019158221 | A1 | 23 May 2019 | BR | 112020009678 | A2 | 10 November 2020 |
| | | | | US | 10680751 | B2 | 09 June 2020 |
| | | | | US | 2020280394 | A1 | 03 September 2020 |
| | | | | US | 11368248 | B2 | 21 June 2022 |
| | | | | KR | 20200088812 | A | 23 July 2020 |
| | | | | KR | 102366770 | B1 | 24 February 2022 |
| | | | | TW | 201924292 | A | 16 June 2019 |
| | | | | TWI | 746904 | B | 21 November 2021 |
| | | | | SG | 11202003424 | QA | 28 May 2020 |
| | | | | KR | 20210083407 | A | 06 July 2021 |
| | | | | EP | 3711208 | A1 | 23 September 2020 |

Form PCT/ISA/210 (patent family annex) (July 2022)

**INTERNATIONAL SEARCH REPORT**
Information on patent family members

| International application No. |
| :--- |
| **PCT/CN2023/120173** |

| Patent document cited in search report | Publication date (day/month/year) | Patent family member(s) | | | Publication date (day/month/year) |
| :--- | :--- | :--- | :--- | :--- | :--- |
| | | EP | 3711208 | C0 | 30 August 2023 |
| | | JP | 2021503826 | A | 12 February 2021 |
| | | JP | 7012850 | B2 | 28 January 2022 |
| | | WO | 2019099940 | A1 | 23 May 2019 |

Form PCT/ISA/210 (patent family annex) (July 2022)